# EUROPEAN PATENT APPLICATION

(11) **EP 4 539 640 A2**
(43) Date of publication of application: **16.04.2025**
(21) Application number: 25158792.9
(22) Date of filing: 31.01.2022
(51) Int. Cl.: H10H 20/819, H10H 20/855

(54) **MICRO LED, MICRO LED ARRAY PANEL AND MANUFACUTURING METHOD THEREOF**

(62) Divisional of application: 22922964.6
(71) Applicant: Jade Bird Display (Shanghai) Limited, Shanghai 201306 (CN)
(72) Inventor: ZHU, Yuankun, Shanghai, 201306 (CN); FANG, Anle, Shanghai, 201306 (CN); LIU, Deshuai, Shanghai, 201306 (CN)
(74) Representative: Finnegan Europe LLP

(57) **Abstract**

A micro LED includes a first type semiconductor layer; and a light emitting layer formed on the first type semiconductor layer; a first type cap layer formed at a bottom surface of the light emitting layer and between the first type semiconductor layer and the light emitting layer; wherein the first type semiconductor layer includes a mesa structure, a trench, and a ion implantation fence separated from the mesa structure, the trench extending up through the first type semiconductor layer and extending up into at least part of the first type cap layer; and the ion implantation fence is formed around the trench and the trench is formed around the mesa structure; wherein an electrical resistance of the ion implantation fence is higher than an electrical resistance of the mesa structure .

## Description

### TECHNICAL FIELD

The present disclosure generally relates to light emitting diode, and more particularly, to a micro light emitting diode (LED), a micro LED array panel, and a manufacturing method thereof.

### BACKGROUND

Inorganic micro pixel light emitting diodes, also referred to as micro light emitting diodes, micro LEDs or µ-LEDs, are of increasing importance because of their use in various applications including self-emissive micro-displays, visible light communications, and optogenetics. The micro LEDs exhibit higher output performance than conventional LEDs due to better strain relaxation, improved light extraction efficiency, and uniform current spreading. The micro LEDs also exhibit improved thermal effects, fast response rate, larger work temperature range, higher resolution, color gamut and contrast, and lower power consumption, and can be operated at higher current density compared with conventional LEDs.

The inorganic micro LEDs are conventionally III -V group epitaxial layers formed as multiple mesas. A space is formed between the adjacent micro LEDs in the conventional micro LEDs structures to avoid carriers in the epitaxial layer spreading from one mesa to an adjacent mesa. However, the space which is formed between the adjacent micro LEDs can reduce an active light emitting area and decrease light extraction efficiency. If there is no space between the adjacent micro LEDs, the active light emitting area would be increased and the carriers in the epitaxial layer would spread laterally to the adjacent mesa, which reduces the light emitting efficiency of the micro LED. Furthermore, if there is no space formed between the adjacent mesas, cross talk will be produced between the adjacent micro LEDs, which would interfere with LEDs operation.

However, smaller micro LEDs with higher current densities will experience red-shift, lower maximum efficiency, and inhomogeneous emission at high current density, which has been attributed to fabrication process damage that results in degraded electrical injection. In addition, the peak external quantum efficiencies (EQEs) and internal quantum efficiency (IQE) are largely decreased with decreasing chip size. The decreased EQE appears due to nonradiative recombination caused by etching damage and the decreased IQE is attributed to poor current injection and electron leakage current of micro LEDs.

The above discussion is only provided to assist in understanding the technical problem overcome by the present disclosure, and does not constitute an admission that the above is prior art.

### SUMMARY OF THE DISCLOSURE

Embodiments of the present disclosure provide a micro LED. The micro LED includes a first type semiconductor layer; and a light emitting layer formed on the first type semiconductor layer; a first type cap layer formed at a bottom surface of the light emitting layer and between the first type semiconductor layer and the light emitting layer; wherein the first type semiconductor layer includes a mesa structure, a trench, and a ion implantation fence separated from the mesa structure, the trench extending up through the first type semiconductor layer and extending up into at least part of the first type cap layer; and the ion implantation fence is formed around the trench and the trench is formed around the mesa structure; wherein an electrical resistance of the ion implantation fence is higher than an electrical resistance of the mesa structure.

Embodiments of the present disclosure provide a method for manufacturing a micro LED. The method includes providing an epitaxial structure, wherein the epitaxial structure includes a first type semiconductor layer, a first type cap layer, a light emitting layer, a second type cap layer, and a second type semiconductor layer sequentially from top to bottom; patterning the first type semiconductor layer to form a mesa structure, a trench, and a fence; depositing a bottom contact on the mesa structure; and performing an ion implantation process into the fence to form an ion implantation fence.

Embodiments of the present disclosure provide a micro LED. The micro LED includes a first type semiconductor layer; a first type cap layer formed on the first type semiconductor layer; a light emitting layer formed on the first type cap layer; a second type cap layer formed on the light emitting layer; a second type semiconductor layer formed on the second type cap layer; and an integrated circuit (IC) back plane formed at a bottom surface of the first type semiconductor layer; wherein the second type semiconductor layer includes a mesa structure, a trench, and an ion implantation fence separated from the mesa structure; the trench extends down through the second type semiconductor layer and extends down into at least part of the second type cap layer; and the ion implantation fence is formed around the trench and the trench is formed around the mesa structure; wherein an electrical resistance of the ion implantation fence is higher than an electrical resistance of the mesa structure; wherein a conductive type of the first type semiconductor layer is different from a conductive type of the second type semiconductor layer .

Embodiments of the present disclosure provide a method for manufacturing a micro LED. The method includes providing an epitaxial structure, wherein the epitaxial structure includes a first type semiconductor layer, a first type cap layer, a light emitting layer, a second type cap layer, and a second type semiconductor layer sequentially from top to bottom; bonding the epitaxial structure with an integrated circuit (IC) backplane; patterning the second type semiconductor layer to form a mesa structure, a trench, and a fence; depositing a top contact on the mesa structure; performing an ion implantation process into the fence; and depositing a top conductive layer on a top surface of the second type semiconductor layer, on a top contact, and in the trench.

Embodiments of the present disclosure provide a micro LED. The micro LED includes a first type semiconductor layer; a first type cap layer formed on the first type semiconductor layer; a light emitting layer formed on the first type cap layer; a second type cap layer formed on the light emitting layer; and a second type semiconductor layer formed on the second type cap layer; wherein the first type semiconductor layer includes a first mesa structure, a first trench, and a first ion implantation fence separated from the first mesa structure, the first trench extending up through the first type semiconductor layer and extending up into at least part of the first type cap layer; and the first ion implantation fence is formed around the first trench and the first trench is formed around the first mesa structure; and an electrical resistance of the first ion implantation fence is higher than an electrical resistance of the first mesa structure; and the second type semiconductor layer includes a second mesa structure, a second trench, and a second ion implantation fence separated from the second mesa structure; and the second ion implantation fence is formed around the second trench and the second trench is formed around the second mesa structure; and an electrical resistance of the second ion implantation fence is higher than an electrical resistance of the second mesa structure; wherein a conductive type of the first type semiconductor layer is different from a conductive type of the second type semiconductor layer.

Embodiments of the present disclosure provide a method for manufacturing a micro LED. The method includes a process I comprising patterning a first type semiconductor layer; and implanting first ions into the first type semiconductor layer; and a process II comprising patterning a second type semiconductor layer; and implanting second ions into the second type semiconductor layer.

Embodiments of the present disclosure provide micro LED array panel. The micro LED array panel includes a plurality of the above described micro LEDs.

### BRIEF DESCRIPTION OF THE DRAWINGS

Embodiments and various aspects of the present disclosure are illustrated in the following detailed description and the accompanying figures. Various features shown in the figures are not drawn to scale.
**FIGs. 1A-1F** are structural diagrams showing a side sectional view of respective different variants of a first exemplary micro LED, according to some embodiments of the present disclosure.
**FIG. 2** is a structural diagram showing a bottom view of the first exemplary micro LED, according to some embodiments of the present disclosure.
**FIG. 3** is a structural diagram showing a side sectional view of another variant of the first exemplary micro LED, according to some embodiments of the present disclosure.
**FIG. 4** is a structural diagram showing a side sectional view of another variant of the first exemplary micro LED, according to some embodiments of the present disclosure.
**FIG. 5** shows a flow chart of a method for manufacturing the first exemplary micro LED, according some embodiments of the present disclosure.
**FIGs. 6A-6J** are structural diagrams showing a side sectional view of a micro LED manufacturing process at each step of the method shown in **FIG. 5****,** according to some embodiments of the present disclosure.
**FIG. 7** is a structural diagram showing a side sectional view of adjacent ones of the micro LED of the first exemplary micro LED, according to some embodiments of the present disclosure.
**FIG. 8** is a structural diagram showing a bottom view of the adjacent micro LEDs in **FIG. 7****,** according to some embodiments of the present disclosure.
**FIG. 9** is a structural diagram showing a side sectional view of adjacent ones of the micro LED of the first exemplary micro LED, according to some embodiments of the present disclosure.
**FIGs. 10A-10F** are structural diagrams showing a side sectional view of respective different variants of a second exemplary micro LED, according to some embodiments of the present disclosure.
**FIG. 11** is a structural diagram showing a top view of the second exemplary micro LED, according to some embodiments of the present disclosure.
**FIGs. 12A** and **12B** is a structural diagram showing a side sectional view of other variants of the second exemplary micro LED, according to some embodiments of the present disclosure.
**FIG. 13** is a structural diagram showing a side sectional view of another variant of the second exemplary micro LED, according to some embodiments of the present disclosure.
**FIG. 14** shows a flow chart of a method for manufacturing the second exemplary micro LED, according some embodiments of the present disclosure.
**FIGs. 15A-15F** are structural diagrams showing a side sectional view of a micro LED manufacturing process at each step of the method shown in **FIG. 14****,** according to some embodiments of the present disclosure.
**FIG. 16** is a structural diagram showing a side sectional view of adjacent ones of the micro LED of the second exemplary micro LED, according to some embodiments of the present disclosure.
**FIG. 17** is a structural diagram showing a top view of the adjacent micro LEDs in **FIG. 16****,** according to some embodiments of the present disclosure.
**FIG. 18** is a structural diagram showing a side sectional view of adjacent ones of the micro LED in **FIG. 12B****,** according to some embodiments of the present disclosure.
**FIG. 19A-19F** are structural diagrams showing a side sectional view of respective different variants of a third exemplary micro LED, according to some embodiments of the present disclosure.
**FIG. 20** is a structural diagram showing a side sectional view of another variant of a third exemplary micro LED, according to some embodiments of the present disclosure.
**FIG. 21** shows a flow chart of a method for manufacturing the third exemplary micro LED, according some embodiments of the present disclosure.
**FIGs. 22A-22D** are structural diagrams showing a side sectional view of a micro LED manufacturing process at steps 2110-2113 of the method shown in **FIG. 21****,** according to some embodiments of the present disclosure.
**FIGs. 23A** and **23B** are structural diagrams showing a side sectional view of other variants of a third exemplary micro LED, according to some embodiments of the present disclosure.
**FIG. 24** is a structural diagram showing a side sectional view of adjacent ones of the micro LED in **FIG. 23A****,** according to some embodiments of the present disclosure.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims. Particular aspects of the present disclosure are described in greater detail below. The terms and definitions provided herein control, if in conflict with terms and/or definitions incorporated by reference.

The present disclosure provides a micro LED which can avoid nonradiative recombination at sidewalls of a mesa according to a structure of a semiconductor layer and continuously formed light emitting layer. Furthermore, compared with conventional micro LEDs, a space between adjacent mesas can be decreased largely due to an ion implantation fence. Therefore, the integration level of the micro LEDs in a chip is increased and the active light emitting efficiency is improved. Furthermore, the micro LED provided by the present disclosure can also increase the active light emitting area and improve the image quality.

### Embodiments 1

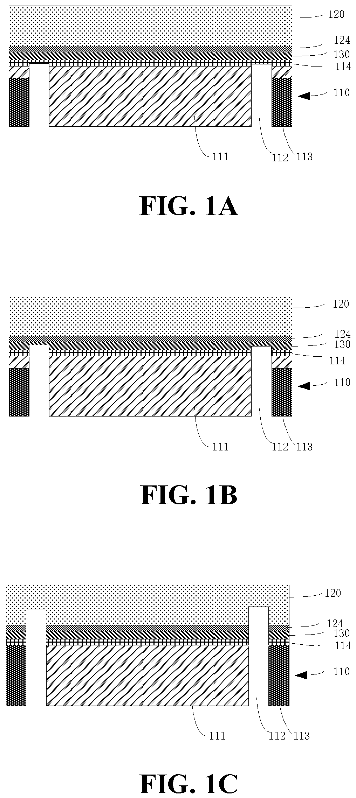

**FIGs. 1A-1F** are structural diagrams showing a side sectional view of respective different variants of a first exemplary micro LED, according to some embodiments of the present disclosure.

Referring to **FIGs. 1A-1F****,** the micro LED includes a first type semiconductor layer 110, a first type cap layer 114, a light emitting layer 130, a second type cap layer 124, and a second type semiconductor layer 120. The light emitting layer 130 is formed on the first type cap layer 114 over the first type semiconductor layer 110, and the second type semiconductor layer 120 is formed on the second type cap layer 124 over the light emitting layer 130. The thickness of the first type semiconductor layer 110 is greater than the thickness of the second type semiconductor layer 120.

A conductive type of the first type semiconductor layer 110 is different from a conductive type of the second type semiconductor layer 120. In some embodiments, the conductive type of the first type semiconductor layer 110 is P type and the conductive type of the second type semiconductor layer 120 is N type. In some embodiments, the conductive type of the second type semiconductor layer 120 is P type and the conductive type of the first type semiconductor layer 110 is N type. For example, a material of the first type semiconductor layer 110 can be selected from one or more of p-GaAs, p-GaP, p-AlInP, p-GaN, p-InGaN, or p-AlGaN. The material of the second type semiconductor layer 120 can be selected from one or more of n-GaAs, n-AlInP, n-GaInP, n-AlGaAs, n-AlGaInP, n-GaN, n-InGaN, or n-AlGaN. A conductive type of the first type cap layer 114 is the same as the conductive type of the first type semiconductor layer 110 and a conductive type of the second type cap layer 124 is the same as the second type semiconductor layer 120.

The first type semiconductor layer 110 includes a mesa structure 111, a trench 112 and an ion implantation fence 113. The ion implantation fence 113 is separated from the mesa structure 111 by the trench 112. The trench 112 and the ion implantation fence 113 are annular around the mesa structure 111.

The ion implantation fence 113 includes a light absorption material for absorbing light from the mesa structure 111. A conductive type of the light absorption material is the same as the conductive type of the first type semiconductor layer 110. Preferably, the light absorption material is selected from one or more of p-GaAs, p-GaP, p-AlInP, p-GaN, p-InGaN, or p-AlGaN. Additionally, the ion implantation fence 113 is formed at least by implanting ions into a fence formed from the first type semiconductor layer 110. Preferably, the ion type implanted into the fence is selected from one or more of H, N, Ar, Kr, Xe, As, O, C, P, B, Si, S, Cl, or F.

Furthermore, the width of the ion implantation fence 113 is not greater than 50% of the diameter of the mesa structure 111. In some embodiments, the width of the ion implantation fence 113 is not greater than 10% of the diameter of the mesa structure 111. Preferably, the width of the ion implantation fence 113 is not greater than 200 nm, the diameter of the mesa structure 111 is not greater than 2500 nm, and the thickness of the first type semiconductor layer 110 is not greater than 300 nm.

In some embodiments, the width of the trench 112 is not greater than 50% of the diameter of the mesa structure 111. In some embodiments, the width of the trench 112 is not greater than 10% of the diameter of the mesa structure 111. Preferably, the width of the first trench 112 is not greater than 200 nm.

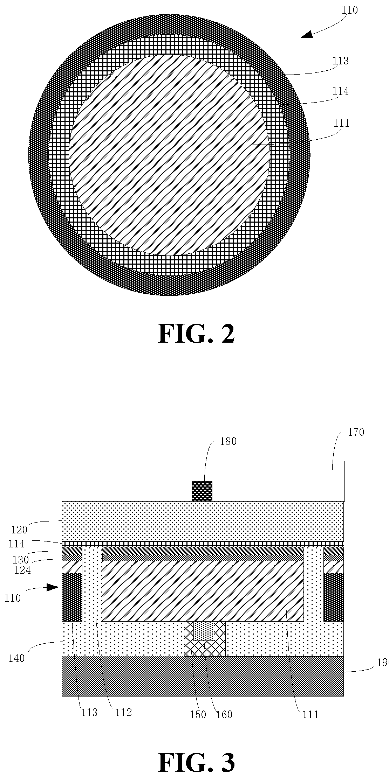

In some embodiments, the top surface of the ion implantation fence 113 is lower than or aligned with the top surface of the first type semiconductor layer 110. Therefore, the ion implantation fence 113 can contact the first type cap layer 114 but cannot contact the light emitting layer 130. The top surface of the ion implantation fence 113 can be formed at any position within the first type semiconductor layer 110. As shown in **FIG. 1A****,** the trench 112 extends up through the first type semiconductor layer 110 and into an interior of the first type cap layer 114. A top surface of the trench 112 is higher than a top surface of the first type semiconductor layer 110. A top surface of the ion implantation fence 113 is lower than the top surface of the trench 112. **FIG. 2** is a structural diagram showing a bottom view of the first exemplary micro LED as shown in **FIG. 1A****,** according to some embodiments of the present disclosure. **FIG. 2** shows a bottom view of the first type semiconductor layer 110 in which the ion implantation fence 113 is separated from the mesa structure 111 by the trench 112. The ion implantation fence 113 is formed around the trench and the trench is formed around the mesa structure 111. Since the trench extends up through the first type semiconductor layer 110 and into the interior of the first type cap layer 114, the first type cap layer 114 can be seen through the trench in the bottom view.

In some embodiments, the trench 112 extends up through the first type semiconductor layer 110 and the first type cap layer 114 and reaches the light emitting layer 130. In some embodiments, referring to **FIG. 1B****,** the trench 112 extends up through the first type semiconductor layer 110 and the first type cap layer 114, and further extends into an interior of the light emitting layer 130. In some embodiments, the trench 112 extends up through the first type semiconductor layer 110, the first type cap layer 114 and the light emitting layer 130. Furthermore, in some embodiments, the trench 112 extends up through the first type semiconductor layer 110, the first type cap layer 114 and the light emitting layer 130, and further extends up into an interior of the second type cap layer 124. Furthermore, in some embodiments, referring to **FIG. 1C****,** the trench 112 extends up through the first type semiconductor layer 110, the first type cap layer 114, the light emitting layer 130 and the second type cap layer 124, and further extends up into an interior of the second type semiconductor layer 120.

Referring to **FIG. 1C****,** in some embodiments, the top surface of the ion implantation fence 113 is aligned with the top surface of the first type semiconductor layer 110.

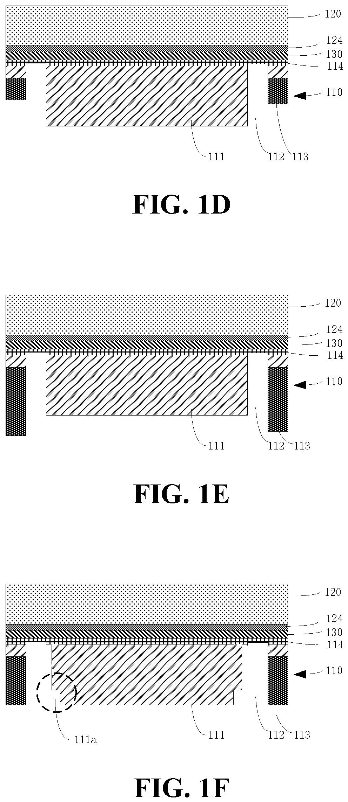

Additionally, the bottom surface of the ion implantation fence 113 can be formed at any position. Preferably, the bottom surface of the ion implantation fence 113 is aligned with the bottom surface of the first type semiconductor layer 110. Referring to **FIG. 1D****,** in some embodiments, the bottom surface of the ion implantation fence 113 is higher than the bottom surface of the first type semiconductor layer 110. Referring to **FIG. 1E****,** in some embodiments, the bottom surface of the ion implantation fence 113 is lower than the bottom surface of the first type semiconductor layer 110.

In some embodiments, as shown in **FIG. 1F****,** the mesa structure 111 includes a stair structure 111a. In some embodiments, the mesa structure 111 can have one or more stair structures.

**FIG. 3** is a structural diagram showing a side sectional view of another variant of the first exemplary micro LED, according to some embodiments of the present disclosure. As shown in **FIG. 3****,** the micro LED further includes a bottom isolation layer 140 filled in the trench 112. Preferably, the material of the bottom isolation layer 140 is selected from one or more of SiO2, SiNx, Al2O3, AlN, HfO2, TiO2, or ZrO2.

In this embodiment, an integrated circuit (IC) backplane 190 is formed under the first type semiconductor layer 110 and is electrically connected with the first type semiconductor layer 110 via a connection structure 150. As shown in **FIG. 3****,** the connection structure 150 is a connection pillar.

The micro LED further includes a bottom contact 160. The bottom contact 160 is formed at the bottom of the first type semiconductor layer 110. An upper surface of the connection structure 150 is connected with the bottom contact 160 and a bottom surface of the connection structure 150 is connected with the IC backplane 190.

Referring to **FIG. 3****,** in some embodiments, the micro LED further includes a top contact 180 and a top conductive layer 170. The top contact 180 is formed on the top of the second type semiconductor layer 120. The top conductive layer 170 is formed on the top of the second type semiconductor layer 120 and the top contact 180. The conductive type of the top contact 180 is the same as the conductive type of the second type semiconductor layer 120. For example, in some embodiments, the conductive type of the second type semiconductor layer 120 is N type and the conductive type of the top contact 180 is N type. In some embodiments, the conductive type of the second type semiconductor layer 120 is P type and the conductive type of the top contact 180 is P type. The top contact 180 is made of metal or metal alloy, such as, AuGe, AuGeNi, etc. The top contact 180 is used for forming an ohmic contact between the top conductive layer 170 and the second type semiconductor layer 120, to optimize the electrical properties of the micro LED. The diameter of the top contact 180 is about 20-50 nm and the thickness of the top contact 180 is about 10~20nm.

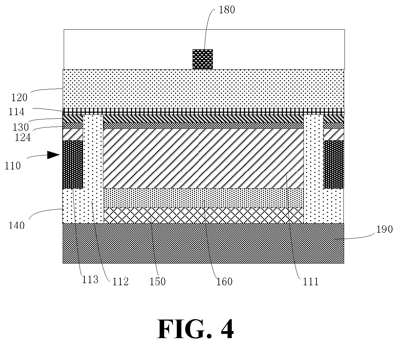

**FIG. 4** is a structural diagram showing a side sectional view of another variant of the first exemplary micro LED, according to some embodiments of the present disclosure. As shown in **FIG.4****,** the connection structure 150 is a metal bonding layer for bonding the micro LED with the IC backplane 190. Additionally, the bottom contact 160 is a bottom contact layer in this variant.

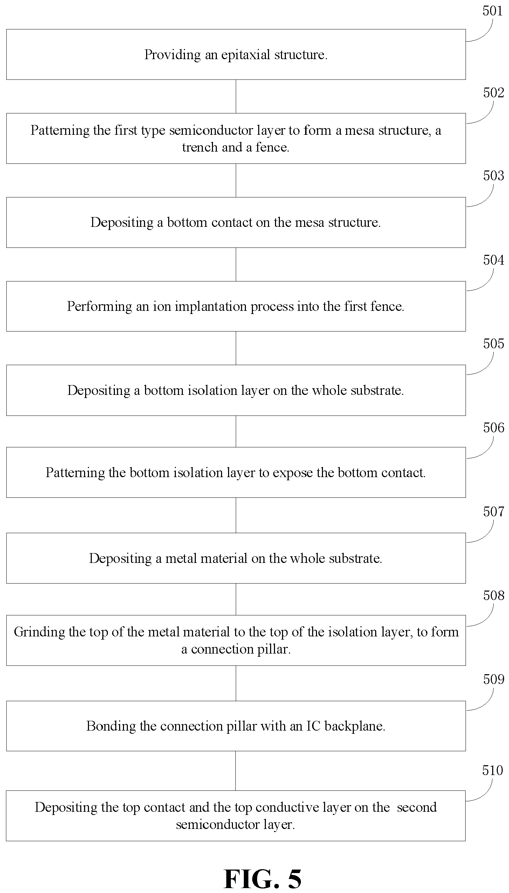

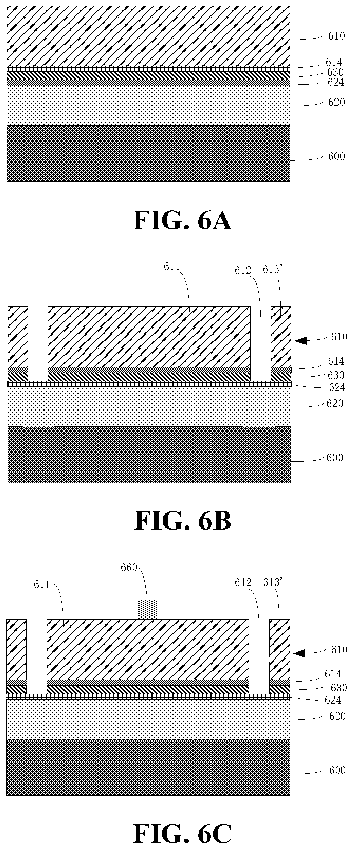

**FIG. 5** shows a flow chart of a method 500 for manufacturing the first exemplary micro LED, for example, the micro LED shown in **FIG. 3****,** according some embodiments of the present disclosure. The method 500 for manufacturing the micro LED includes steps 501-510. **FIG. 6A** to **FIG. 6J** are structural diagrams showing a side sectional view of a micro LED manufacturing process at each step (i.e., steps 501-510) corresponding to the method 500 shown in **FIG. 5****,** according to some embodiments of the present disclosure.

Referring to **FIG. 5** and **FIGs. 6A** to **6J,** in step 501, an epitaxial structure is provided. As shown in **FIG. 6A****,** the epitaxial structure includes a first type semiconductor layer 610, a first type cap layer 614, a light emitting layer 630, a second type cap layer 624 and a second type semiconductor layer 620 sequentially from top to bottom. The epitaxial structure is grown on a substrate 600. The substrate 600 can be GaN, GaAs, etc.

In step 502: referring to **FIG. 6B****,** the first type semiconductor layer 610 is patterned to form a mesa structure 611, a trench 613, and a fence 613'.

The step 502 may further include: etching the first type semiconductor layer 610, the first type cap layer 614, and the light emitting layer 630 in sequence, and stopping the etching on the second type cap layer 624. As shown in **FIG. 6B****,** the bottom surface of the first trench 612 contacts the second type cap layer 624, and locates on the second type cap layer 624. The first type semiconductor layer 610 is etched by a conventional dry etching process, such as, a plasma etching process, which can be understood be those skilled in the field.

In some embodiments, the step 502 may include: etching the first type semiconductor layer, the first type cap layer and the light emitting layer in sequence, and stopping the etching in the light emitting layer. For example, referring back to **FIG. 1B****,** the top surface of the trench 121 contacts the light emitting layer 130, and locates in the light emitting layer 130.

In some embodiments, the step 502 may include: etching the first type semiconductor layer, the first type cap layer, the light emitting layer, the second type cap layer, and the second type semiconductor layer in sequence, and stopping the etching in the second type semiconductor layer. For example, referring back to, **FIG. 1C****,** the top surface of the trench 121 contacts the second type semiconductor layer 120, and locates in the second type semiconductor layer 120.

Referring back to **FIG. 1A****,** the first type semiconductor layer 110 is etched and the etching is stopped in the first type cap layer 114 to avoid the light emitting layer 130 being etched in the patterning process. The bottom of the trench 112 does not reach the light emitting layer 130. The first type semiconductor layer 110 is etched by a conventional dry etching process, such as, a plasma etching process, which can be understood be those skilled in the field.

In step 503: referring to **FIG. 6C****,** a bottom contact 660 is deposited on the mesa structure 611.

Before the bottom contact 660 deposited, a first protective mask (not shown) is used to protect an area where the bottom contact 660 will not be formed. Then, the material of the bottom contact 660 is deposited on the first protective mask and on the first type semiconductor layer 610 by a conventional vapor deposition process, such as a physical vapor deposition process or a chemical vapor deposition process. After the deposition process, the first protective mask is removed from the first type semiconductor layer 610 and the material on the first protective mask is also removed with the first protective mask to form the bottom contact 660 on the mesa structure 611.

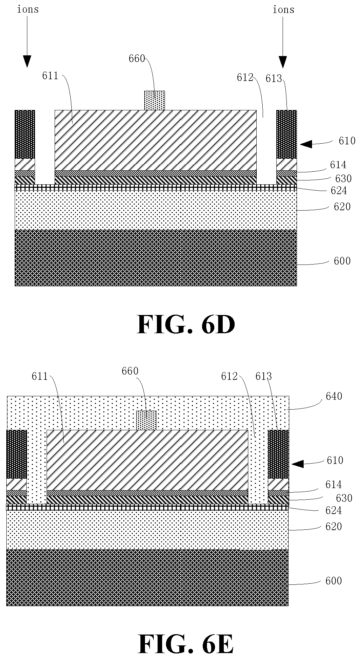

In step 504: referring to **FIG. 6D****,** an ion implantation process is performed into the fence 613'. The arrows illustrate a direction of the ion implantation process.

In combination with **FIG. 6C****,** the ions are implanted into the fence 613' (as shown in **FIG. 6C**) to form an ion implantation fence 613 (as shown in **FIG. 6D**) by the ion implantation process, as shown in **FIG. 6D****.** Before the ion implantation process, a second protective mask (not shown) is formed on an area in which no ions are to be implanted. Then, the ions are implanted into the exposed fence 613'. Subsequently, the second protective mask is removed by a conventional chemical etching process, which can be understood by those skilled in the field. Preferably, the implanting energy is 0~500Kev, and the implanting dose is 1E10-9E17.

In step 505: referring to **FIG. 6E****,** a bottom isolation layer 640 is deposited on the whole substrate 600. That is, the bottom isolation layer 640 is deposited on the first type semiconductor layer 610. The first type semiconductor layer 610 and the bottom contact 660 are covered by the bottom isolation layer 640, and the trench 612 is filled by the bottom isolation layer 640. The bottom isolation layer 640 is deposited by a conventional chemical vapor deposition process.

As shown in **FIG. 6E****,** the bottom isolation layer 640 fills into the trench 612. Therefore, the bottom isolation layer 640 is formed on the sidewall and the bottom of the trench 612. The bottom isolation layer 640 is also formed at the sidewalls of the first type semiconductor layer 610, first mesa structure 611, the first type cap layer 614 and the light emitting layer 630 in the first trench 612, and on the surface of the second type cap layer 624 in the first trench 612. In some embodiments, referring back to **FIG. 1A****,** the bottom isolation layer can be formed at the sidewalls of the mesa structure 111, the first type semiconductor layer 110, and the ion implantation fence 113 and formed at the surface of the first type cap layer 114 in the trench 112. In some embodiments, referring back to **FIG. 1B****,** the bottom isolation layer can be formed at the sidewalls of the mesa structure 111, the first type semiconductor layer 110, the ion implantation fence 113, and the first type cap layer 114 in the first trench 112, and formed at a surface within the light emitting layer 130 in the first trench 112. In some embodiments, referring back to **FIG. 1C****,** the bottom isolation layer can be formed at the sidewalls of the mesa structure 111, the ion implantation fence 113, the first type cap layer 114, the light emitting layer 130, and the second type cap layer 124 in the trench 112, and formed at a surface within the second type semiconductor layer 120 in the trench 112.

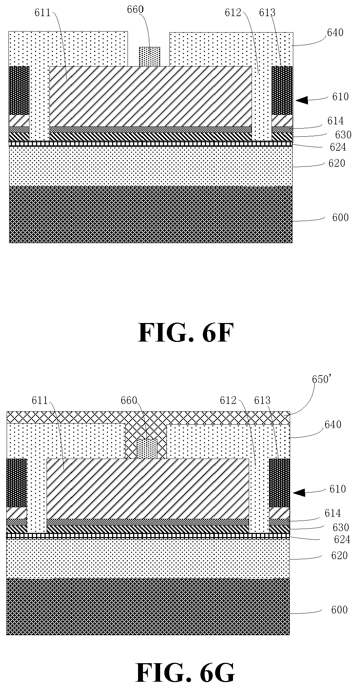

In step 506: referring to **FIG. 6F****,** the bottom isolation layer 640 is patterned to expose the bottom contact 660. The bottom isolation layer 640 is etched by a photo etching process and a dry etching process.

In step 507: referring to **FIG. 6G****,** a metal material 650' is deposited on the whole substrate 600. That is, the metal material 650' is deposited on the bottom isolation layer 640 and the bottom contact 660. The metal material is deposited by a conventional physical vapor deposition method.

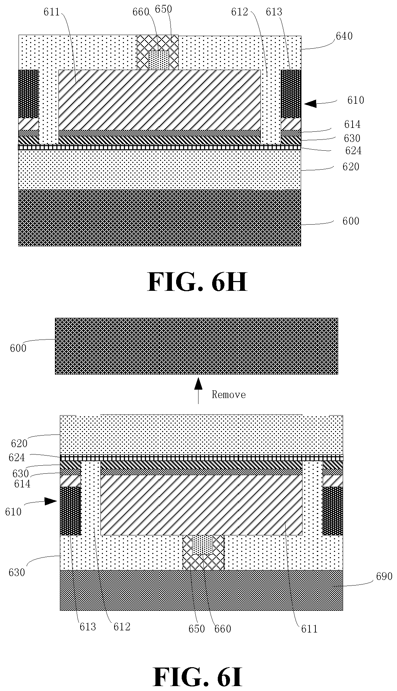

In step 508: referring to **FIG. 6H****,** the top of the metal material is ground to the top of the bottom isolation layer 640, to form a connection structure 650 such as a connection pillar. In some embodiments, the metal material is ground by a Chemical Mechanical Polishing (CMP) process.

In step 509: referring to **FIG. 6I**, the connection pillar 650 is bonded with an IC backplane 690. The epitaxial structure is firstly turned upside down. Then, the connection pillar 650 is bonded with a contact pad of the IC backplane 690 by a metal bonding process. Then, the substrate 600 is removed by a conventional separation method, such as, a laser stripping method, or a chemical etching method. The arrows illustrate a removal direction of the substrate 600.

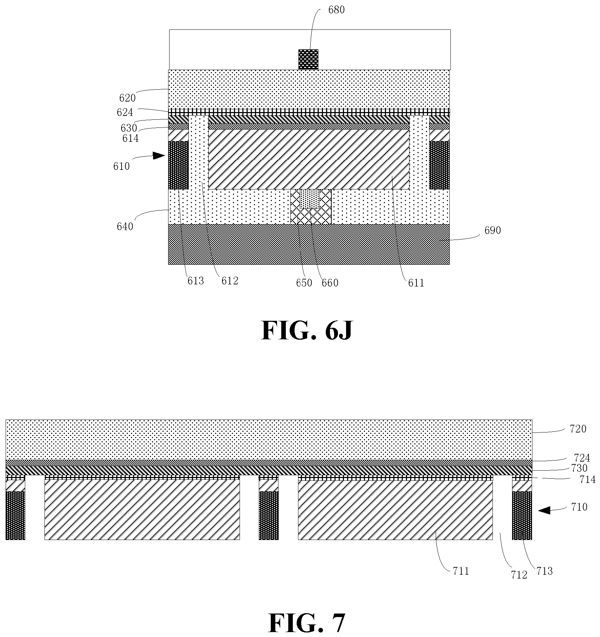

In step 510: referring to **FIG. 6J****,** a top contact 680 and a top conductive layer 670 can be deposited in sequence on the second type semiconductor layer 620 by a conventional vapor deposition method.

A micro LED array panel is further provided by some embodiments of the present disclosure. The micro LED array panel includes a plurality of micro LEDs as described above and shown in **FIGs. 1A-1F****,** **FIG. 3** and **FIG. 4****.** These micro LEDs can be arranged in an array in the micro LED array panel.

**FIG. 7** is a structural diagram showing a side sectional view of adjacent ones of the first exemplary micro LED, according to some embodiments of the present disclosure. As shown in **FIG. 7****,** a micro LED array panel includes a first type semiconductor layer 710, continuously formed in the micro LED array panel; a first type cap layer 714, continuously formed on the first type semiconductor layer 710; a light emitting layer 730, continuously formed on the first type cap layer 714; a second type cap layer 724, continuously formed on the light emitting layer 730; and a second type semiconductor layer 720, continuously formed on the second type cap layer 724.

A conductive type of the first type semiconductor layer 710 is different from a conductive type of the second type semiconductor layer 720. For example, in some embodiments, the conductive type of the first type semiconductor layer 710 is P type, and the conductive type of the second type semiconductor layer 720 is N type. In some embodiments, the conductive type of the second type semiconductor layer 720 is P type, and the conductive type of the first type semiconductor layer 710 is N type. The thickness of the first type semiconductor layer 710 is greater than the thickness of the second type semiconductor layer 720. In some embodiments, the material of the first type semiconductor layer 710 is selected from one or more of p-GaAs, p-GaP, p-AlInP, p-GaN, p-InGaN, or p-AlGaN. The material of the second type semiconductor layer 720 is selected from one or more of n-GaAs, n-AlInP, n-GaInP, n-AlGaAs, n-AlGaInP, n-GaN, n-InGaN, or n-AlGaN. A conductive type of the first type cap layer 714 is the same as the conductive type of the first type semiconductor layer 710 and a conductive type of the second type cap layer 724 is the same as the second type semiconductor layer 720.

The first type semiconductor layer 710 includes multiple mesa structures 711, multiple trenches 712, and multiple ion implantation fences 713 separated from the mesa structures 711 by the trenches 712. The top surface of the ion implantation fence 713 is aligned with or lower than the top surface of the first type semiconductor layer 710. Thus, the ion implantation fence 713 cannot reach the light emitting layer 730. The top of the ion implantation fence 713 can be formed at any position. Additionally, the bottom surface of the ion implantation fence 713 can be formed at any position. The relationship of the top surface of the ion implantation fence 713, the top surface of the first type semiconductor layer 710, and the top surface of the trench 712 can be seen in the micro LED shown in **FIGs. 1A-1E****,** the description of which will not be further described here. Additionally, the relationship of the bottom surface of the ion implantation fence 713 and the bottom surface of the first type semiconductor layer 710 can be seen in the micro LED shown in **FIGs. 1E-1G,** which will not be further described herein. The mesa structure can have one or multiple stair structures in another embodiment as seen in the mesa structure shown in **FIG. 1H.**

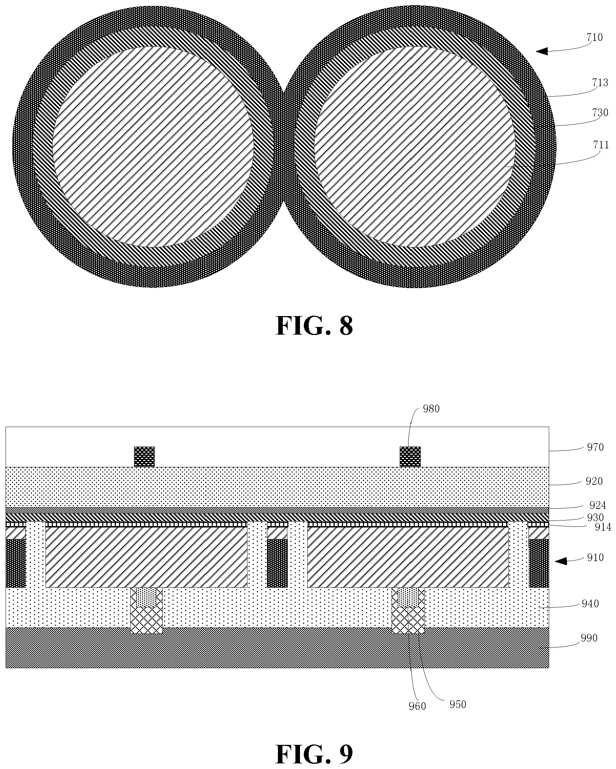

**FIG. 8** is a structural diagram showing a bottom view of the adjacent micro LEDs in **FIG. 7****,** according to some embodiments of the present disclosure. As shown in **FIG. 8****,** the ion implantation fences 713 are formed around the trench 712 and between the adjacent mesa structures 711. Furthermore, in each micro LED, the ion implantation fence 713 is formed around the trench 712 and the trench 712 is formed around the mesa structure 711. The electrical resistance of the ion implantation fence 713 is higher than the electrical resistance of the mesa structure 711. Since the trench extends up through the first type semiconductor layer 710 and through the first type cap layer 714, the light emitting layer 730 can be seen through the trench in the bottom view.

In some embodiments, the space between the adjacent sidewalls of the adjacent ones of the mesa structure 711 can be adjusted. For example, in some embodiments, the space between the adjacent sidewalls of the mesa structures 711 is not greater than 50% of the diameter of the mesa structure 711. In some embodiments, the space between the adjacent sidewalls of the mesa structures 711 is not greater than 30% of the diameter of the mesa structure 711. Preferably, the space between the adjacent sidewalls of the mesa structure 711 is not greater than 600 nm. Additionally, in some embodiments, the width of the ion implantation fence 713 can be adjusted. For example, the width of the ion implantation fence 713 can be not greater than 50% of the diameter of the mesa structure 711. In some embodiments, the width of the ion implantation fence 713 can be not greater than 10% of the diameter of the mesa structure 711. Preferably, in the micro LED array panel, the width of the ion implantation fence 713 is not greater than 200 nm.

**FIG. 9** is a structural diagram showing a side sectional view of adjacent ones of the first exemplay micro LED, in a micro LED array panel, according to some embodiments of the present disclosure. As shown in **FIG. 9****,** the micro LED array panel further includes a bottom isolation layer 940 formed on a first type semiconductor layer 910 and filled in a trench 912. Preferably, in some embodiments, the material of the bottom isolation layer 940 is one or more of SiO2, SiNx, or Al2O3, AlN, HfO2, TiO2, or ZrO2. In addition, an IC backplane 990 is continuously formed under the first type semiconductor layer 910 and is electrically connected with the first type semiconductor layer 910 via a connection structure 950. The micro LED array panel further includes a bottom contact 960 formed at the bottom of the first type semiconductor layer 910. Further detail of the bottom isolation layer 940, the IC backplane 990, the bottom contact 960 and the connection structure 950 are shown in the micro LED in **FIGs. 3** and **4****,** respectively as corresponding to the isolation layer 140, the IC backplane 190, the bottom contact 160, and the connection structure 150, which will not be further described.

In this embodiment, the micro LED array panel further includes a top contact 980 and a top conductive layer 970. The top contact 980 is formed on the top of a second type semiconductor layer 920. The top conductive layer 970 is formed on the top of the second type semiconductor layer 920 and the top contact 980. A conductive type of the top contact 980 is the same as a conductive type of the second type semiconductor layer 920. For example, in some embodiments, the conductive type of the second type semiconductor layer 920 is N type and the conductive type of the top contact 980 is N type. In some embodiments, the conductive type of the second type semiconductor layer 920 is P type and the conductive type of the top contact 980 is P type. The top contact 980 is made of metal or metal alloy, such as, AuGe, AuGeNi, etc. The top contact 980 is used for forming ohmic contact between the top conductive layer 970 and the second type semiconductor layer 920, to optimize the electrical properties of the micro LEDs. The diameter of the top contact 980 is about 20-50 nm and the thickness of the top contact 980 is about 10~20nm.

The micro LED array panel can be manufactured by the method 500 as shown in **FIG. 5****,** which will not be further described.

### Embodiment 2

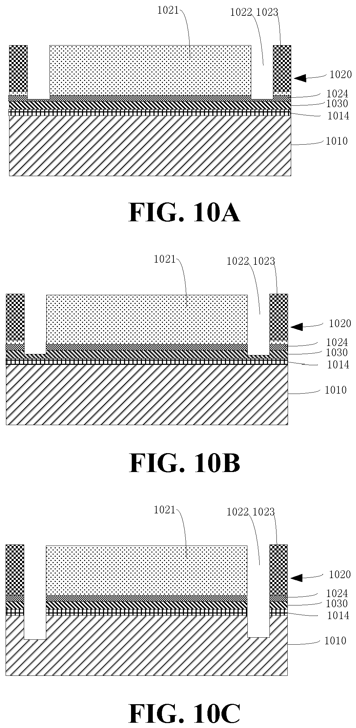

**FIGs. 10A -10F** are structural diagrams showing a side sectional view of respective different variants of a second exemplary micro LED, according to some embodiments of the present disclosure. As shown in **FIG. 10A****,** the micro LED includes a first type semiconductor layer 1010, a first type cap layer 1014, a light emitting layer 1030, a second type cap layer 1024, and a second type semiconductor layer 1020. A conductive type of the first type semiconductor 1010 is different from a conductive type of the second type semiconductor layer 1020. For example, the conductive type of the first type semiconductor 1010 is P type and the conductive type of the second type semiconductor layer 1020 is N type. The thickness of the first type semiconductor layer 1010 is greater than the thickness of the second type semiconductor layer 1020. The material of the first type semiconductor layer 1010 is selected from one or more of p-GaAs, p-GaP, p-AlInP, p-GaN, p-InGaN, or p-AlGaN, and the material of the second type semiconductor layer 1020 is selected from one or more of n-GaAs, n-AlInP, n-GaInP, n-AlGaAs, n-AlGaInP, n-GaN, n-InGaN, or n-AlGaN. A conductive type of the first type cap layer 1014 is the same as the conductive type of the first type semiconductor layer 1010 and a conductive type of the second type cap layer 1024 is the same as the second type semiconductor layer 1020.

The second type semiconductor layer 1020 includes a mesa structure 1021, a trench 1022, and an ion implantation fence 1023 separated from the mesa structure 1021. The bottom surface of the ion implantation fence 1023 is aligned with or higher than the bottom surface of the second type semiconductor layer 1020. Thus, the ion implantation fence 1023 can reach the second type cap layer 1024 but cannot reach the light emitting layer 1030. The bottom surface of the ion implantation fence 1023 can be formed at any position. Furthermore, the ion implantation fence 1023 is formed around the trench 1022 and the trench 1022 is formed around the mesa structure 1021. The electrical resistance of the ion implantation fence 1023 is higher than the electrical resistance of the mesa structure 1021.

The ion implantation fence 1023 includes a light absorption material for absorbing light from the mesa structure 1021. A conductive type of the light absorption material is the same as the conductive type of the second type semiconductor layer 1020. Preferably, the light absorption material is selected from one or more of GaAs, GaP, AlInP, GaN, InGaN, or AlGaN. Additionally, the ion implantation fence 1023 is formed at least by implanting ions into the second type semiconductor layer 1020. Preferably, the ion type implanted into the second type semiconductor layer 1020 is selected from one or more of H, N, Ar, Kr, Xe, As, O, C, P, B, Si, S, Cl, or F.

Furthermore, the width of the ion implantation fence 1023 can be adjusted. For example, in some embodiments, the width of the ion implantation fence 1023 is not greater than 50% of the diameter of the mesa structure 1021. In some embodiments, the width of the ion implantation fence 1023 is not greater than 10% of the diameter of the mesa structure 1021. Preferably, the width of the ion implantation fence 1023 is not greater than 200 nm. The diameter of the mesa structure 1021 is not greater than 2500 nm. The thickness of the second type semiconductor layer 1020 is not greater than 100 nm.

In some embodiments, the width of the trench 1022 is not greater than 50% of the diameter of the mesa structure 1021. In some embodiments, the width of the trench 1022 is not greater than 10% of the diameter of the mesa structure 1021. Preferably, the width of the trench 1022 is not greater than 200 nm.

There is no limitation on the depth of the trench 1022. In some embodiments, the trench 1022 can extend down through the second type semiconductor layer 1020 and enter into the interior of the second type cap layer 1024. In some embodiments, the trench 1022 can extend down through the second type semiconductor layer 1020 and the second type cap layer 1024, and reach the light emitting layer 1030. In some embodiments, the trench 1022 can extend down through the second type semiconductor layer 1020 and the second type cap layer 1024, and extend into the interior of the light emitting layer 1030. In some embodiments, the trench 1022 can extend down through the second type semiconductor layer 1020, the second type cap layer 1024, and the light emitting layer 1030. Furthermore, in some embodiments, the trench 1022 can extend down through the second type semiconductor layer 1020, the second type cap layer 1024, and the light emitting layer 1030, and extend down into the interior of the first type cap layer 1014. Furthermore, in some embodiments, the trench 1022 can extend down through the second type semiconductor layer 1020, the second type cap layer 1024, the light emitting layer 1030, and the first type cap layer 1014, and extend down into the interior of the first type semiconductor layer 1010.

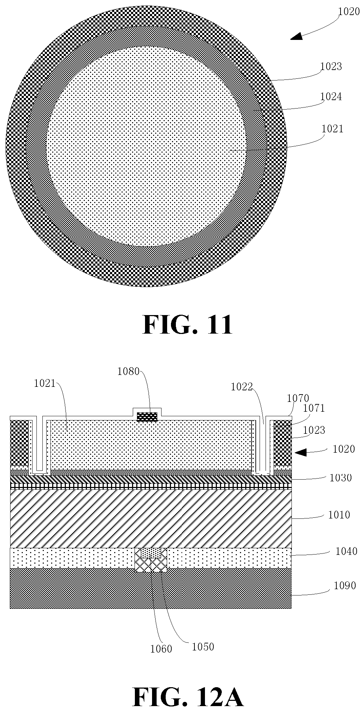

In some embodiments, as shown in **FIG. 10A****,** the trench 1022 extends down through the bottom surface of the second type semiconductor layer 1020 and into an interior of the second type cap layer 1024. The bottom surface of the trench 1022 is lower than the bottom of the second type semiconductor layer 1020. Furthermore, the bottom surface of the second ion implantation fence 1023 is higher than the bottom surface of the second trench 1022. **FIG. 11** is a structural diagram showing a top view of the second exemplary micro LED shown in **FIG. 10A****.** **FIG. 11** shows a top view of the second type semiconductor layer 1020 in which the ion implantation fence 1023 is separated from the mesa structure 1021 by the trench 1022. Herein, the ion implantation fence 1023 is formed around the trench 1022 and the trench 1022 is formed around the mesa structure 1021. Since the trench 1022 extends down through the bottom surface of the second type semiconductor layer 1020 and into the interior of the second type cap layer 1024, the second type cap layer 1024 can be seen through the trench 1022 in the top view.

In some embodiments, as shown in **FIG. 10B****,** the trench 1022 extend down through the bottom surface of the second type semiconductor layer 1020 and the second type cap layer 1024. The bottom surface of the ion implantation fence 1023 is higher than the bottom surface of the second trench 1022. In some embodiments, as shown in **FIG. 10C****,** the bottom surface of the ion implantation fence 1023 is aligned with the bottom surface of the second type semiconductor layer 1020.

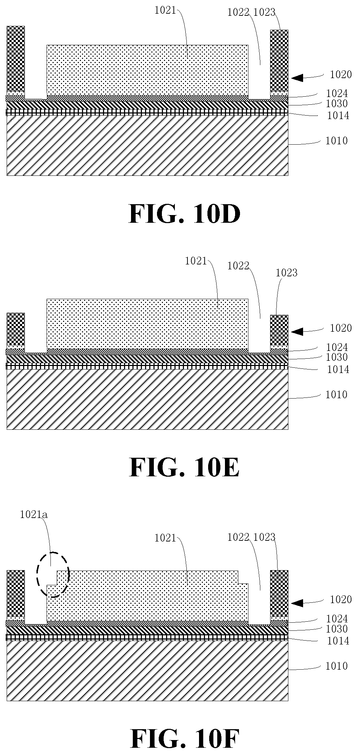

Additionally, in some embodiments, the top surface of the ion implantation fence 1023 can be formed at any position. In some embodiments, as shown in **FIG. 10D****,** the top surface of the ion implantation fence 1023 is higher than the top surface of the second type semiconductor layer 1020. In some embodiments, as shown in **FIG. 10E****,** the top surface of the ion implantation fence 1023 is lower than the top surface of the second type semiconductor layer 1020.

In some embodiments, as show in **FIG. 10F****,** the mesa structure 1021 includes one stair structure 1021a. In some embodiments, the mesa structure 1021 can have multiple stair structures.

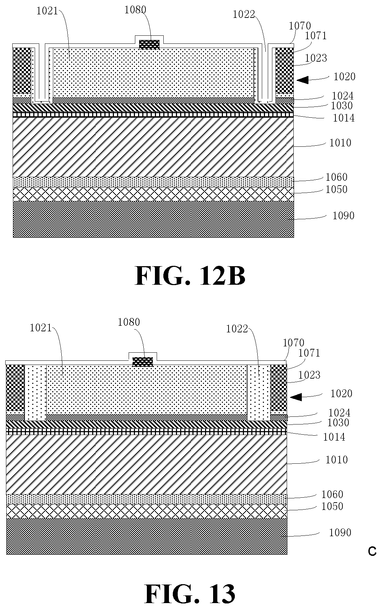

**FIGs. 12A** and **12B** are structural diagram showing a side sectional view of other variants of the second exemplary micro LED, according to some embodiments of the present disclosure. As shown in **FIG. 12A****,** the micro LED further includes a bottom isolation layer 1040 formed under the first type semiconductor layer 1010. Preferably, the material of the bottom isolation layer 1040 is selected from one or more of SiO2, SiNx, or Al2O3. An integrated circuit (IC) backplane 1090 is formed under the first type semiconductor layer 1010 and is electrically connected with the first type semiconductor layer 1010 via a connection structure 1050. The connection structure 1050 is a connection pillar. The micro LED further includes a bottom contact 1060 formed at the bottom of the first type semiconductor layer 1010. An upper surface of the connection structure 1050 is connected with a bottom contact 1060 and the bottom of the connection structure 1050 is connected with the IC backplane 1090. In this embodiment, the bottom contact 1060 protrudes from the first type semiconductor layer 1010 as a bottom contact of the micro LED.

Additionally, in some embodiments, the micro LED further includes a top contact 1080 and a top conductive layer 1070. The top contact 1080 is formed on the top of the second type semiconductor layer 1020. The top conductive layer 1070 is formed on the top surface of the second type semiconductor layer 1020 and the top surface of the top contact 1080, and covers the sidewalls of the second trench 1022. Preferably, a dielectric layer 1071 is formed on a sidewall and bottom surface of the trench 1022. A conductive type of the top contact 1080 is the same as a conductive type of the second type semiconductor layer 1020. For example, the conductive type of the second type semiconductor layer 1020 is N type and the conductive type of the top contact 1080 is N type. The top contact 1080 is made of metal or metal alloy, such as, AuGe, AuGeNi, etc. The top contact 1080 is used for forming an ohmic contact between the top conductive layer 1070 and the second type semiconductor layer 1020, to optimize the electrical properties of the micro LED. The diameter of the top contact 1080 is about 20-50 nm and the thickness of the top contact 1080 is about 10~20nm.

Referring to **FIG. 12B****,** the connection structure 1050 can be a metal bonding layer for bonding the micro LED with the IC backplane 1090. Additionally, the bottom contact 1060 is a bottom contact layer in this embodiment.

**FIG. 13** is a structural diagram showing a side sectional view of another variant of the second exemplary micro LED, according to some embodiments of the present disclosure. As shown in **FIG. 13****,** a dielectric layer 1071 can be full filled in the second trench 1022. A conductive layer 1070 is formed on the whole substrate. In some embodiments, the dielectric layer 1071 can be formed on the top surface of second type semiconductor layer 1020. In some embodiments, the dielectric layer can be a multiple layer structure, and the material for a first portion of the dielectric layer in the trench and the material for a second portion of the dielectric layer can be different.

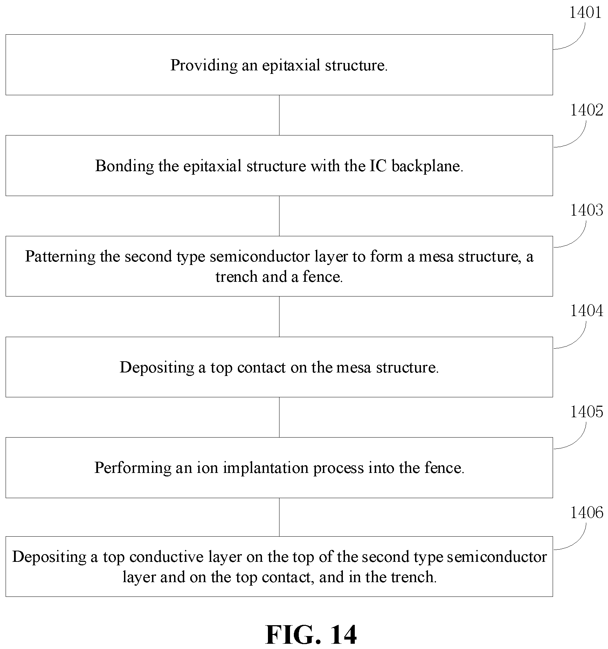

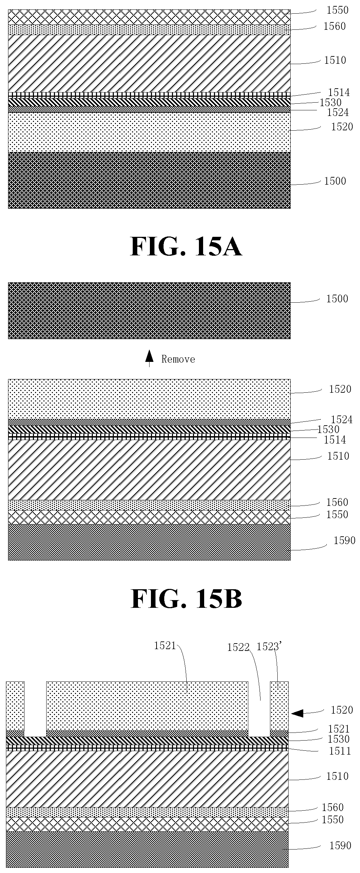

**FIG. 14** shows a flow chart of a method 1400 for manufacturing the second exemplary micro LED, for example the micro LED shown in **FIG. 13****,** according some embodiments of the present disclosure. As shown in **FIG. 14****,** the method for manufacturing the micro LED includes steps 1401-1406. **FIGs. 15A-15F** are structural diagrams showing a side sectional view of a micro LED manufacturing process at each step (i.e., steps 1401 to 1406) of the method 1400 shown in **FIG. 14****,** according to some embodiments of the present disclosure.

Referring to **FIG. 14** and **FIGs. 15A****-15F,** in step 1401: an epitaxial structure is provided. As shown in **FIG. 15A****,** the epitaxial structure includes a first type semiconductor layer 1510, a first type cap layer 1514, a light emitting layer 1530, a second type cap layer 1524, and a second type semiconductor layer 1520 sequentially from top to bottom. The epitaxial structure is grown on a substrate 1500. The substrate 1500 can be GaN, GaAs, etc.

Preferably, before turning upside down the epitaxial structure, a bottom contact layer 1560 used as the bottom contact is deposited on the top surface of the first type semiconductor layer 1510. Then, a metal bonding layer which is used as a connection structure 1550 is deposited on the top surface of the bottom contact layer 1560.

In step 1402: referring to **FIG. 15B****,** the epitaxial structure is bonded with an IC backplane 1590. The epitaxial structure is firstly turned upside down. Subsequently, the connection structure 1550is bonded with a contact pad of the IC backplane 1590 by a metal bonding process. Finally, the substrate 1500 is removed by a conventional separation method, such as, a laser stripping method, or a chemical etching method. The arrow illustrates a removal direction of the substrate 1500.

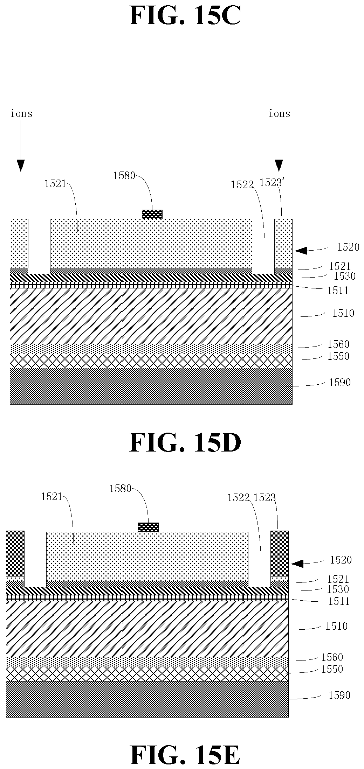

In step 1403: referring to **FIG. 15C****,** the second type semiconductor layer 1520 is patterned to form a mesa structure 1521, a trench 1522, and a fence 1523'.

In some embodiments, the step 1403 further includes: etching the second type semiconductor layer and the second type cap layer, and stopping the etching on the top surface of the light emitting layer 1030, to avoid the light emitting layer being etched in the patterning process. As shown in **FIG. 15C****,** the bottom surface of the trench 1522 contacts the light emitting layer 1530.

In some embodiments, the step 1403 further includes: etching the second type semiconductor layer and the light emitting layer in sequence, and stopping the etching in the light emitting layer 1030. Referring back to **FIG. 10B****,** the bottom surface of the trench 1022 contacts the light emitting layer 1030, and is located in the light emitting layer 1030.

In some embodiments, the step 1403 further includes: etching the second type semiconductor layer, the light emitting layer, and the first type semiconductor layer in sequence, and stopping the etching in the first type semiconductor layer. Referring back to **FIG. 10C****,** the bottom of the trench 1022 contacts the first type semiconductor layer 1010, and is located in the first type semiconductor layer 1010.

The second type semiconductor layer 1520 is etched by a conventional dry etching process, such as a plasma etching process, which can be understood be those skilled in the field.

In step 1404: referring to **FIG. 15D****,** a top contact 1580 is deposited on the mesa structure 1521. Before the top contact 1580 is deposited, a first protective mask (not shown) is used to protect an area where the top contact 1580 will not be formed. Then, the material of the top contact 1580 is deposited on the first protective mask and on the second type semiconductor layer 1520 by a conventional vapor deposition process, such as a physical vapor deposition process or a chemical vapor deposition process. After the deposition process, the first protective mask is removed from the second type semiconductor layer 1520 and the material on the first protective mask is also removed with the first protective mask to form the top contact 1580 on the mesa structure 1521.

In step 1405: referring to **FIG. 15E****,** an ion implantation process is performed into the fence 1523'. With reference also to **FIG. 15D****,** the ions are implanted into the fence 1523' (as shown in **FIG. 15D**) to form an ion implantation fence 1523 (as shown in **FIG. 15E**) by an ion implantation process. The arrows illustrate a direction of the ion implantation process. Before the ion implantation process, a second protective mask (not shown) is formed on the area in which no ions are to be implanted. Then, the ions are implanted into the exposed fence 1523' (as shown in **FIG. 15D**). Subsequently, the second protective mask is removed by a conventional chemical etching process, which can be understood by those skilled in the field. Preferably, the implanting energy is 0~500Kev and the implanting does is 1E10-9E17.

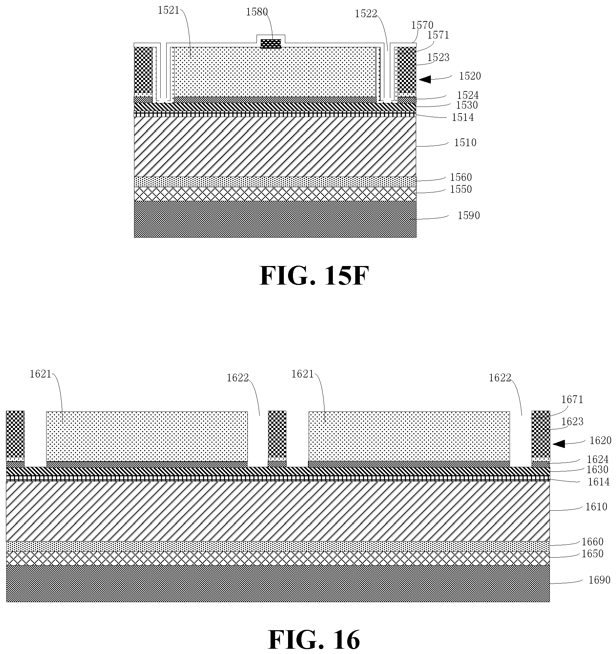

In step 1406: referring to **FIG. 15F****,** a top conductive layer 1570 is deposited on the top of the second type semiconductor layer 1520 and on the top contact 1580, and covers the sidewalls of the trench 1522. The top conductive layer 1570 is deposited by a conventional physical vapor deposition process.

Before forming the top conductive layer 1570, a dielectric layer 1571 is formed on the sidewalls and the bottom surface of the trench 1522. As shown in **FIG. 15F****,** the dielectric layer 1571 is formed on the sidewall of the second type semiconductor layer 1520, the mesa structure 1521, and the second type cap layer 1524 in the trench 1522 and on the surface of the light emitting layer 1530 in the trench 1522. In some embodiments, referring back to **FIG. 10B****,** the dielectric layer can be formed on the sidewall of the second type semiconductor layer 1020, the mesa structure 1021, and the light emitting layer 1030 in the trench 1022 and on the surface of the light emitting layer 1030 in the trench 1022. In some embodiments, referring back to **FIG. 10C****,** the dielectric layer can be formed on the sidewall of the mesa structure 1021, the second type cap layer 1024, the light emitting layer 1030, the first type cap layer 1014, and on the sidewall and surface of the first type semiconductor layer 1010 in the trench 1022.

Referring back to **FIG. 15F****,** the top conductive layer 1570 is formed on the surface of the dielectric layer 1571 and covers the sidewalls and bottom of the trench 1522, on the top surface of the second mesa structure 1521 and the top surface of ion implantation fence 1523. Furthermore, in some embodiments, referring back to **FIG. 13****,** the dielectric layer 1071 can be fully filled in the second trench 1022. A micro lens can be further formed on the top conductive layer, which can be understood by those skilled in the field.

A micro LED array panel is further provided according to some embodiments of the present disclosure. The micro LED array panel includes a plurality of micro LEDs as described above shown in **FIGs. 10A-10H,** **FIGs. 12A****,** **12B** and **FIG. 13****.** These micro LEDs can be arranged in an array in the micro LED array panel.

**FIG. 16** is a structural diagram showing a side sectional view of adjacent ones of the second exemplary micro LED, according to some embodiments of the present disclosure. As shown in **FIG. 16****,** a micro LED array panel includes a first type semiconductor layer 1610, continuously formed in the micro LED array panel; a first type cap layer 1614, continuously formed on the first type semiconductor layer 1610; a light emitting layer 1630, continuously formed on the first type semiconductor layer 1610; a second type cap layer 1624, continuously formed on the light emitting layer 1630; and a second type semiconductor layer 1620, continuously formed on the second type cap layer 1624.

The second type semiconductor layer 1620 includes multiple mesa structures 1621, multiple trenches 1622, and multiple ion implantation fences 1623 separated from the mesa structures 1621 by the trenches 1622. The bottom surface of the ion implantation fence 1623 is not lower than the bottom surface of the second type semiconductor layer 1620.

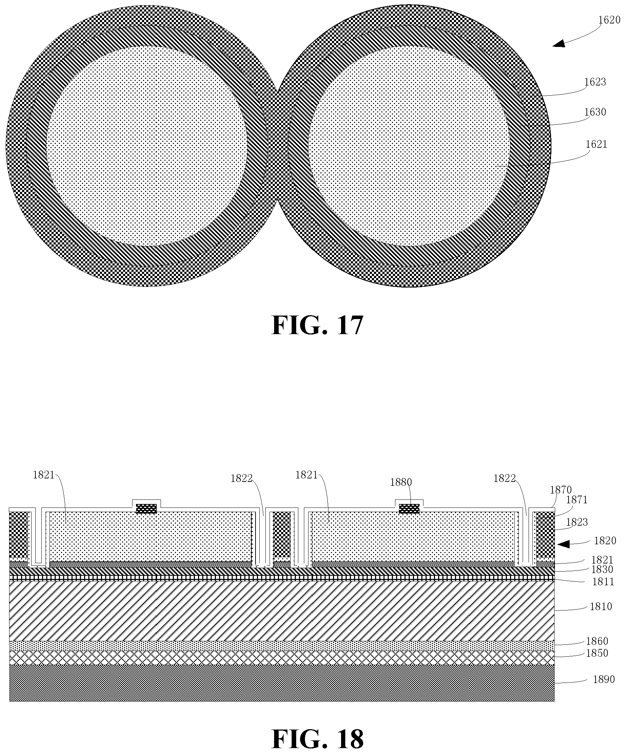

**FIG. 17** is a structural diagram showing a top view of the adjacent micro LEDs in **FIG. 16****,** according to some embodiments of the present disclosure. In **FIG. 17****,** the top view shows the ion implantation fences 1623 are formed around the trench 1622 and between the adjacent mesa structures 1621. The electrical resistance of the ion implantation fence 1623 is higher than the electrical resistance of the mesa structure 1621. The ion implantation fence 1623 is formed around the trench 1622 and the trench 1622 is formed around the mesa structure 1621.

Variations in the relationship of the bottom surface of the ion implantation fence 1623, and the bottom surface of the second type semiconductor layer 1620, and the bottom of the trench 1622 generally correspond to those shown for the micro LED in **FIGs. 10A-10E****,** which will not be further described here. Additionally, in some embodiments, variations in the relationship of the top surface of the ion implantation fence 1623 and the top surface of the second type semiconductor layer 1620 generally correspond to those shown for the micro LED in **FIGs. 10E-10G,** which will not be further described here. In some embodiments, the mesa structure can have one or multiple stair structures as shown in **FIG. 10H.**

In some embodiments, the space between the adjacent sidewalls of adjacent ones of the mesa structures 1621 can be adjusted. For example, in some embodiments, the space between the adjacent sidewalls of the mesa structures 1621 is not greater than 50% of the diameter of the mesa structure 1621. In some embodiments, the space between the adjacent sidewalls of the mesa structures 1621 is not greater than 30% of the diameter of the mesa structure 1621. Preferably, the space between the adjacent sidewalls of the mesa structures 1621 is not greater than 600 nm. Additionally, in some embodiments, the width of the ion implantation fence 1623 can be adjusted. For example, the width of the ion implantation fence 1623 can be not greater than 50% of the diameter of the mesa structure 1621. In some embodiments, the width of the ion implantation fence 1623 can be not greater than 10% of the diameter of the mesa structure 1621. Preferably, in the micro LED array panel, the width of the ion implantation fence 1623 is not greater than 200 nm.

A bottom contact 1660 is formed at the bottom of the first type semiconductor layer 1610. A connection structure 1650 is a metal bonding layer for bonding the micro LED with an IC backplane 1690. The detail of the bottom contact 1660, the connection structure 1650 and the IC backplane 1690 can be found as referring to the above described micro LED in **FIGs. 12A** and **12B****.**

**FIG. 18** is a structural diagram showing a side sectional view of adjacent ones of the micro LED in **FIG. 12B** in a micro LED array panel, according to some embodiments of the present disclosure. As shown in **FIG. 18****,** the micro LED array panel further includes a top contact 1880, a dielectric layer 1871, and a top conductive layer 1870. Further details of the top contact 1880, the dielectric layer 1871 and the top conductive layer 1870 can be understood by also referring to the micro LEDs shown in **FIGs. 10A-10F****,** **FIGs. 12A** and **12B** and **FIG. 13****,** which will not be further described here.

Furthermore, referring back to **FIG. 18****,** an IC backplane 1890 is formed under the first type semiconductor layer 1810 and is electrically connected with the first type semiconductor layer 1810 via a connection structure 1850. The micro LED array panel further includes a bottom contact 1860 formed at the bottom of the first type semiconductor layer 1810. The connection structure 1850 can be a metal bonding layer for bonding the micro LED with the IC backplane 1890. Additionally, in some embodiments, the bottom contact 1860 is a bottom contact layer. Further details of the bottom isolation layer 1840, the IC backplane 1890, the bottom contact 1860, and the connection structure 1850 can be understood by also referring to **FIG. 12B****,** which will not be further described here.

Additionally, further details regarding the features of the micro LED and the ion implantation fence in the micro LED array panel can be understood by also referring to the micro LEDs as shown in **FIGs. 10A-10H,** which will not be further described here.

The micro LED array panel shown in **FIG. 18**can be manufactured by the method of manufacturing the micro LED 1400 as shown in **FIG. 14****,** which will not be further described here.

### Embodiment 3

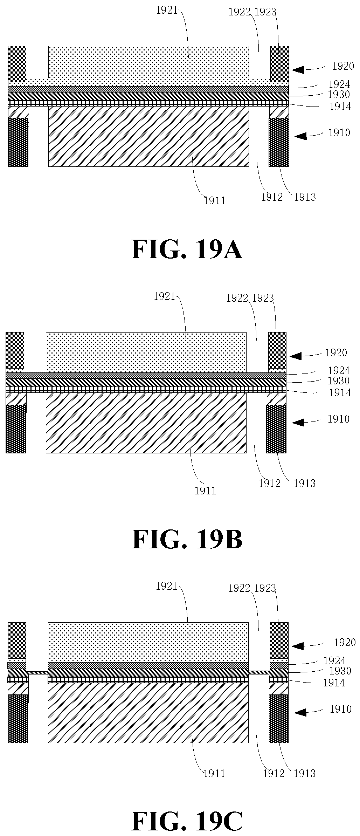

**FIGs. 19A-19F** are structural diagrams showing a side sectional view of respective different variants of a third exemplary micro LED, according to some embodiments of the present disclosure. As shown in **FIG. 19A****,** in some embodiments, the micro LED at least includes a first type semiconductor layer 1910, a first type cap layer 1914, a light emitting layer 1930, a second type cap layer 1924, and a second type semiconductor layer 1920. A conductive type of the first type semiconductor layer 1910 is different from a conductive type of the second type semiconductor layer 1920. For example, in some embodiments, the conductive type of the first type semiconductor layer 1910 is P type and the conductive type of the second type semiconductor layer 1920 is N type. In some embodiments, the conductive type of the second type semiconductor layer 1920 is P type and the conductive type of the first type semiconductor layer 1910 is N type. The thickness of the first type semiconductor layer 1910 is greater than the thickness of the second type semiconductor layer 1920. The thickness of the first type semiconductor layer 1910 can be thinner than the thickness of the second type semiconductor layer 1920. In some embodiments, a material of the first type semiconductor layer 1910 is selected from one or more of p-GaAs, p-GaP, p-AlInP, p-GaN, p-InGaN, or p-AlGaN, and a material of the second type semiconductor layer 1920 is selected from one or more of n-GaAs, n-AlInP, n-GaInP, n-AlGaAs, n-AlGaInP, n-GaN, n-InGaN, or n-AlGaN. A conductive type of the first type cap layer 1914 is the same as the conductive type of the first type semiconductor layer 1910 and a conductive type of the second type cap layer 1924 is the same as the second type semiconductor layer 1920.

The first type semiconductor layer 1910 includes a first mesa structure 1911, a first trench 1912, and a first ion implantation fence 1913 separated from the first mesa structure 1911. The second type semiconductor layer 1920 includes a second mesa structure 1921, a second trench 1922, and a second ion implantation fence 1923 separated from the second mesa structure 1921.

Combined with **FIG. 1A****,** the first trench can extend up through the top of the first type semiconductor layer, and extend into the interior of the first type cap layer. Combined with **FIG. 1B****,** the first trench can extend up through the first type semiconductor layer and the first type cap layer, and contact the light emitting layer. Furthermore, the first trench can extend into the interior of the light emitting layer. In some embodiments, the first trench can extend up through the first type semiconductor layer, the first type cap layer and the light emitting layer. Furthermore, the first trench can extend up into the interior of the second type cap layer. In some embodiments, combined with **FIG. 1C****,** the first trench can extend up through the first type semiconductor layer, the first type cap layer, and the light emitting layer and into the second type cap layer. Furthermore, the first trench can extend up into the interior of the second type semiconductor layer. Additionally, the first trench can extend up through the first type semiconductor layer, the first type cap layer, the light emitting layer, the second type cap layer and the second type semiconductor layer.

Combined with **FIG. 10A****,** the second trench can extend down through the second type semiconductor layer and enter into the interior of the second type cap layer. Additionally, combined with **FIG. 10B****,** the second trench can extend down through the second type semiconductor layer and through the second type cap layer and can reach the light emitting layer. Furthermore, the second trench can extend into the interior of the light emitting layer. In some embodiments, the second trench can extend down through the second type semiconductor layer, the second type cap layer, and the light emitting layer. Furthermore, the second trench can extend down into the interior of the first type cap layer. In some embodiments, combined with **FIG. 10C****,** the second trench can extend down through the second type semiconductor layer, the second type cap layer, the light emitting layer, and the first type cap layer and extend down into the interior of the first type semiconductor layer. Additionally, the second trench can extend down through the second type semiconductor layer, the second type cap layer, the light emitting layer, the first type cap layer, and the first type semiconductor layer.

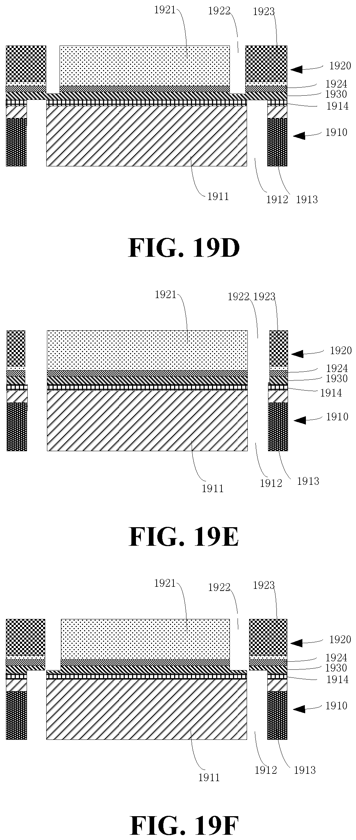

Referring back to **FIGs. 19A-19D****,** the top of the first trench 1912 does not touch the bottom of the second trench 1922, in either the horizontal direction or vertical direction. Part of the light emitting layer 1930 is configured between the top surface of the first trench 1912 and the bottom surface of the second trench 1922. Additionally, in some embodiments, referring to **FIGs. 19E** and **19F****,** the top surface of the first trench 1912 is directly connected with the bottom of the second trench 1922, in the horizontal direction and vertical direction. In some embodiments, as shown in **FIG. 19E****,** there is no light emitting layer between the top of the first trench 1912 and the bottom of the second trench 1922. That is, the first trench 1912 and the second trench 1922 are interconnected when the first trench 1912 and the second trench 1922 extend through to each other in vertical direction. The center of the first trench 1912 can be aligned with or shift from the center of the second trench 1922. In some embodiments, as shown in **FIG. 19D** and **FIG. 19F****,** the first trench 1912 and the second trench 1922 do not correspond with each other in the vertical direction. Additionally, in some embodiments, the diameter of the first trench 1912 from topside down can be the same or different. The diameter of the second trench 1922 from topside down can be the same or different. The diameter of the first trench 1912 can be the same as or different from the diameter of the second trench 1922.

In some embodiments, the center of the first mesa structure 1911 is aligned with the center of the second mesa structure 1921, the center of the first trench 1912 is aligned with the center of the second trench 1922., and the center of the first ion implantation fence 1913 is aligned with the center of the second ion implantation fence 1923.

The relationship of the top surface of the first ion implantation fence 1913, the top surface of the first trench 1912, and the top surface of the first type semiconductor layer 1910 is the same as that of the variants of the micro LED in Embodiment 1 shown in **FIGs. 1A-1D****,** and will not be further described here. The relationship of the bottom of the first ion implantation fence 1913, the bottom of the first trench 1912, and the bottom of the first type semiconductor layer 1910 is the same as that of the variants of the micro LED in Embodiment 1 shown in **FIGs. 1D-1G** of the embodiment 1 and will not be further described here. Furthermore, in some embodiments, the first mesa structure 1911 can have one or multiple stair structures, as shown in **FIG. 1H.**

The relationship of the bottom of the second ion implantation fence 1923, the bottom of the second trench 1922, and the bottom of the second type semiconductor layer 1920 is the same as that of the variants of the micro LED in embodiment 2 shown in **FIGs. 10A-10E** and will not be further described here. The relationship of the top surface of the second ion implantation fence 1923, the top surface of the second trench 1922, and the top surface of the second type semiconductor layer 1920 is the same as that of the micro LED of embodiment 2 shown in **FIGs. 10E-10G** and will not be further described here. Furthermore, in some embodiments, the second mesa structure 1921 can have one or multiple stair structures, as shown in **FIG. 10H.**

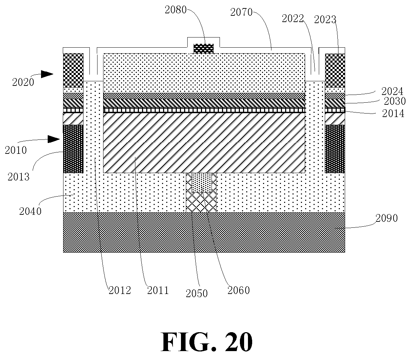

**FIG. 20** is a structural diagram showing a side sectional view of another variant of the third exemplary micro LED, according to some embodiments of the present disclosure. As shown in **FIG. 20****,** the micro LED further includes a bottom isolation layer 2040 filled in a first trench 2012. Preferably, the material of the bottom isolation layer 2040 is one or more of SiO2, SiNx, or Al2O3. An IC backplane 2090 is formed under a first type semiconductor layer 2010 and is electrically connected with the first type semiconductor layer 2010 via a connection structure 2050. Herein, the connection structure 2050 is a connection pillar. The micro LED further includes a bottom contact 2060 formed at the bottom of the first type semiconductor layer 2010. Further detail of the bottom isolation layer 2040, the IC backplane 2090, the connection structure 2050, and the bottom contact 2060 can be found by referring to the description for Embodiment 1, which will not be further described here.

The micro LED further includes a top contact 2080 and a top conductive layer 2070. The top contact 2080 is formed on the top of a second type semiconductor layer 2020. The top conductive layer 2070 is formed on the top of the second type semiconductor layer 2020 and the top contact 2080 and covers the sidewalls and bottom of the second trench 2022. Further details regarding the top contact 2080 and the top conductive layer 2070 can be found by referring to the description for Embodiment 2, which will not be further described here.

Additionally, further details regarding the micro LED shown in **FIG. 20****,** including a first ion implantation fence 2013 and a second ion implantation fence 2023, can be found by referring to the description for Embodiment 1 and Embodiment 2, which will not be further described here.

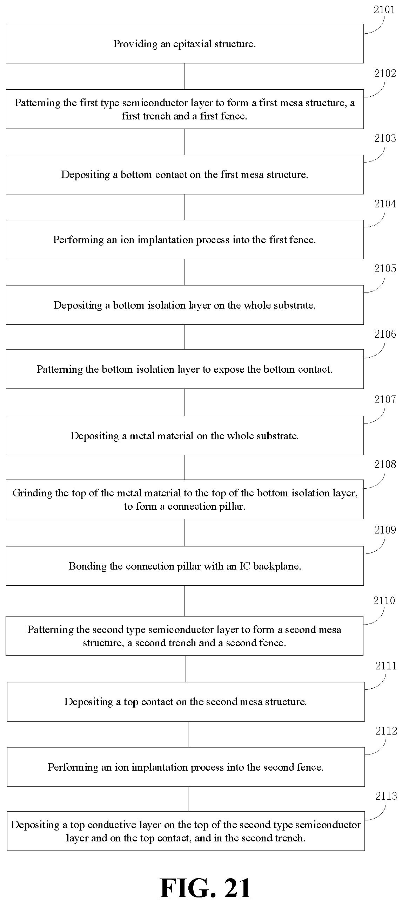

**FIG. 21** shows a flow chart of a method 2100 for manufacturing the third exemplary micro LED, according some embodiments of the present disclosure. The method 2100 includes at least Process I and Process II.

In Process I: the first type semiconductor layer is patterned, and then ions are implanted into the first type semiconductor layer to form a first ion implantation fence.

In Process II: the second type semiconductor layer is patterned, and then ions are implanted into the second type semiconductor layer to form a second ion implantation fence.

Referring to **FIG. 21****,** the Process I at least includes steps 2101-2109, and the Process II at least includes steps 2110-2113.

For Process I, the steps 2101-2109 are similar to the steps 501-509 of method 500 as shown in **FIG. 5****.** The side sectional views for the micro LED being manufactured according to steps 2101-2109 are similar to the views shown in **FIGs. 6A-6I****.** Referring to **FIG. 21** and **FIGs. 6A****-6I,** in step 2101: referring to **FIG. 6A****,** the epitaxial structure is provided. The epitaxial structure includes the first type semiconductor layer 610, the first type cap layer 614, the light emitting layer 630, the second type cap layer 624 and the second type semiconductor layer 620 sequentially from top to bottom. In step 2102: referring to **FIG. 6B****,** the first type semiconductor layer 610 is patterned to form the mesa structure 611, the trench 612 and the fence 613'.

In step 2103: referring to **FIG. 6C****,** the bottom contact 660 is deposited on the mesa structure 611.

In step 2104: referring to **FIG. 6D****,** an ion implantation process is performed into the fence 613'.

In step 2105: referring to **FIG. 6E****,** the isolation layer 640 is deposited on the whole substrate 600.

The bottom isolation layer can be filled into the first trench. In some embodiments, the bottom isolation layer can be formed on the sidewalls of the first mesa structure, the first ion implantation fence, the first type semiconductor layer, the first type cap layer, the light emitting layer and the second type semiconductor layer, the second mesa structure, the second type cap layer, and the second type ion implantation fence in the first trench, which depends on a depth of the first trench.

In step 2106: referring to **FIG. 6F****,** the isolation layer 640 is patterned to expose the bottom contact 660.

In step 2107: referring to **FIG. 6G****,** metal material 650' is deposited on the whole substrate 600.

In step 2108: referring to **FIG. 6H****,** the top of the metal material 650' is ground to the top of the isolation layer 640, to form the connection pillar 650.

In step 2109: referring to **FIG. 6I**, the connection pillar 650 is bonded with the IC backplane 690, and the substructure 600 is removed.

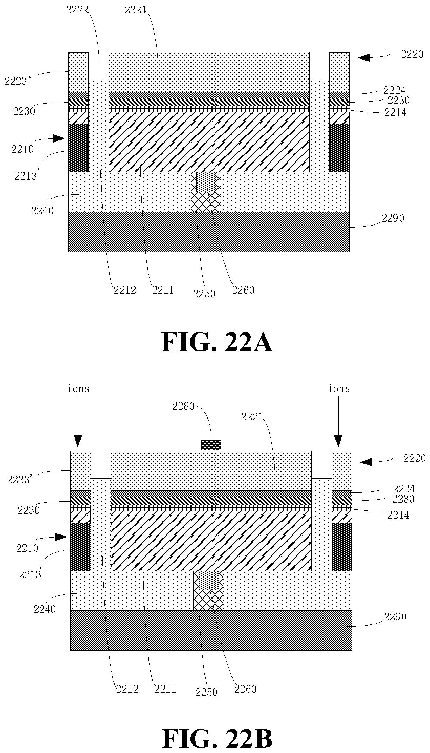

**FIGs. 22A-22D** are structural diagrams showing a side sectional view of the micro LED manufacturing process at steps 2110-2113 of the method 2100 shown in **FIG. 21****,** according to some embodiments of the present disclosure. Referring to **FIG. 21** and **FIGs. 22A-****22D,** in step 2110: referring to **FIG. 22A****,** a second type semiconductor layer 2220 is patterned to form a mesa structure 2221, a trench 2222 and a fence 2223'.

In step 2111: referring to **FIG. 22B****,** a top contact 2280 is deposited on the mesa structure 2221.

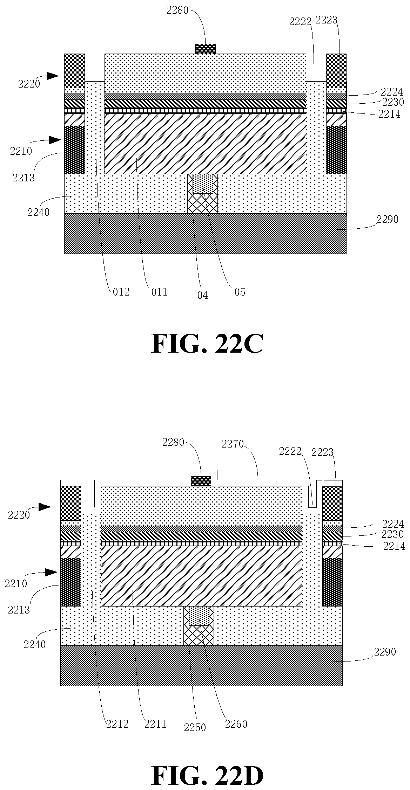

In step 2112: referring to **FIG. 22C****,** an ion implantation process is performed into the fence 2223' to form ion implantation fence 2223. The arrows in **FIG. 22B** illustrate a direction of the ion implantation process.

In step 2113: referring to **FIG. 22D****,** a top conductive layer 2270 is deposited on the top of the second type semiconductor layer 2220 and on the top contact 2280, and in the trench 2222. In some embodiments, the top conductive layer 2270 can be directly formed on the top of the second type semiconductor layer 2220 and on the top contact 2280, and on the sidewalls and bottom of the trench 2222.

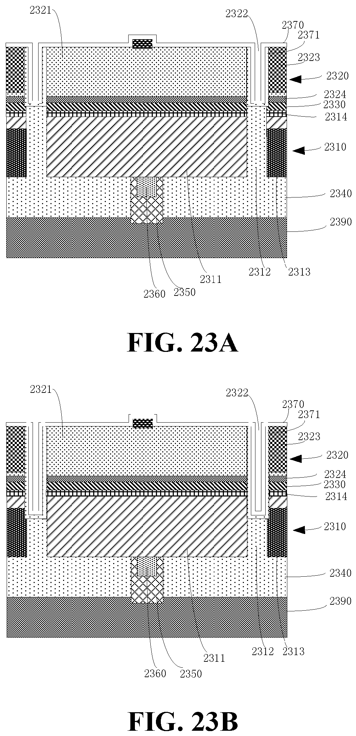

**FIGs. 23A** and **23B** are structural diagrams showing a side sectional view of other variants of a third exemplary micro LED, according to some embodiments of the present disclosure. As shown in **FIG. 23A****,** a bottom isolation layer 2340 is filled in the first trench 2312, and formed on the sidewall of a first mesa structure 2311, a first ion implantation fence 2313, a first type cap layer 2314, and a light emitting layer 2330 in the first trench 2312. Before forming a top conductive layer 2370, a dielectric layer 2371 is formed extending into a second trench 2322. The dielectric layer 2371 is formed on the sidewall and the bottom of a second trench 2322. Furthermore, the dielectric layer 2371 is formed on the sidewall of a second mesa structure 2321, a second type semiconductor layer 2320, a second ion implantation fence 2323, a second type cap layer 2324, and a light emitting layer 2330 in the second trench 2322. Then the top conductive layer 2370 is formed on the surface of the dielectric layer 2371 extending into the second trench 2322, and formed on the top of the second mesa structure 2321 and the top of second ion implantation fence 2323.

In some embodiments, as shown to **FIG. 23B****,** the bottom isolation layer 2340 is filled in the first trench 2312, and formed on the sidewall of the first mesa structure 2311, the first ion implantation fence 2313, and the first type semiconductor layer 2310. The top conductive layer 2370 can be formed extending into the second trench 2322. Furthermore, the dielectric layer 2371 is formed extending into the second trench 2322. The dielectric layer 2371 is formed on the sidewall of the second mesa structure 2321, the second type semiconductor layer 2320, the second ion implantation fence 2323, the second type cap layer 2324, the light emitting layer 2330, the first mesa structure 2311, the first type cap layer 2314, the first ion implantation fence 2313, and the first type semiconductor layer 2310 in the second trench 2322.

The bottom isolation layer 2340 is formed on the sidewalls and the top of the first trench 2312, and the dielectric layer 2371 is formed on the sidewalls and the bottom of the second trench 2322. The thickness of the bottom isolation layer extending into the first trench 2312 depends on a position of the bottom of the second trench 2322 and a position of the top of the first trench 2312. The thickness of the dielectric layer 2371 extending into the second trench 2322 depends on a position of the bottom of the second trench 2322 and a position of the top of the first trench 2312.

A top contact and a bottom contact can be formed on the micro LED according to some embodiments of the present disclosure, which will not be further described here.

Further details of the Process I can be found by reference to the description of steps 501-509 for the Embodiment 1. Further details of the Process II can be found by reference to the description of steps 1403-1406 for the Embodiment 2, which will not be further described here.

A micro LED array panel is further provided according to some embodiments of the present disclosure. The micro LED array panel includes a plurality of micro LEDs as described above and shown in **FIGs. 19A-19E****,** **FIG. 20** and **FIG. 23A** and **23B.** These micro LEDs can be arranged in an array in the micro LED array panel.

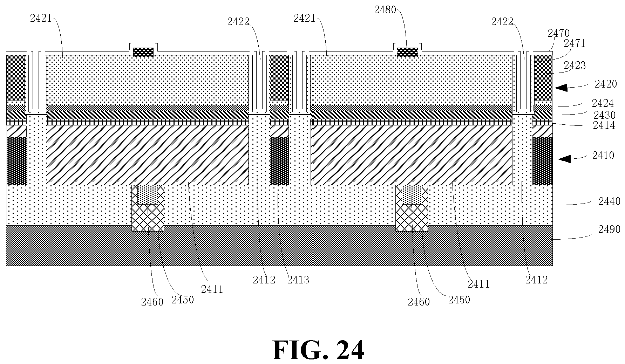

**FIG. 24** is a structural diagram showing a side sectional view of adjacent ones of the micro LED in **FIG. 23A** in a micro LED array panel, according to some embodiments of the present disclosure. As shown in **FIG. 24****,** the micro LED array panel at least includes a first type semiconductor layer 2410 continuously formed in the micro LED array panel; a first type cap layer 2414, continuously formed on the first type semiconductor layer 2410; a light emitting layer 2430 continuously formed on the first type cap layer 2414; a second type cap layer 2424, continuously formed on the light emitting layer 2330; and a second type semiconductor layer 2420, formed on the second type cap layer 2324.

The first type semiconductor layer 2410 includes multiple first mesa structures 2411, multiple first trenches 2412, and multiple first ion implantation fences 2413 separated from the first mesa structures via the first trenches 2412. The top surface of the first ion implantation fence 2413 is lower than the top surface of the first type semiconductor layer 2410. Referring back to **FIG. 8****,** a bottom view of the micro LED array panel without an IC backplane is similar to the bottom view shown in **FIG. 8****.** The first ion implantation fences 2413 are formed around the first trenches 2412 and between the adjacent first type mesa structures 2411. The electrical resistance of the first ion implantation fence 2413 is higher than the electrical resistance of the first mesa structure 2411. Furthermore, the first ion implantation fence 2413 is formed around the first trench 2412 and the first trench 2412 is formed around the first mesa structure 2411.

The second type semiconductor layer 2420 includes multiple second mesa structures 2421, multiple second trenches 2422, and multiple second ion implantation fences 2423 separated from the second mesa structures 2421 via the second trenches 2422. The bottom surface of the second ion implantation fence 2423 is higher than the bottom surface of the second type semiconductor layer 2420. A top view of the micro LED array panel is similar to the top view shown in **FIG. 17** in that the second ion implantation fences 2423 being formed around the second trenches 2422 and between the adjacent second mesa structures 2421. The electrical resistance of the second ion implantation fence 2423 is higher than the electrical resistance of the second mesa structure 2421. The second ion implantation fence 2323 is formed around the second trench 2422 and the second trench 2422 is formed around the second mesa structure 2421.

In some embodiments, the space between the adjacent sidewalls of the first mesa structures 2411 can be adjusted. For example, in some embodiments, the space between the adjacent sidewalls of the first mesa structures 2411 is not greater than 50% of the diameter of the first mesa structure 2411. In some embodiments, the space between the adjacent sidewalls of the first mesa structures 2411 is not greater than 30% of the diameter of the first mesa structure 2411. Preferably, the space between the adjacent sidewalls of the first mesa structures 2411 is not greater than 600 nm. Additionally, in some embodiments, the width of the first ion implantation fence 2413 can be adjusted. For example, in some embodiments, the width of the first ion implantation fence 2413 is not greater than 50% of the diameter of the first mesa structure 2411. In some embodiments, the width of the first ion implantation fence 2313 is not greater than 10% of the diameter of the first mesa structure 2311. Preferably, in some embodiments, in the micro LED array panel, the width of the first ion implantation fence 2413 is not greater than 200 nm. The space between the adjacent sidewalls of the second mesa structure 2421 is not greater than 50% of the diameter of the second mesa structure 2421. In some embodiments, the space between the adjacent sidewalls of the second mesa structure 2421 is not greater than 30% of the diameter of the second mesa structure 2421. Preferably, the space between the adjacent sidewalls of the second mesa structure 2421 is not greater than 600 nm. Additionally, the width of the second ion implantation fence 2423 is not greater than 50% of the diameter of the second mesa structure 2421. In some embodiments, the width of the second ion implantation fence 2423 is not greater than 10% of the diameter of the second mesa structure 2421. Preferably, in the micro LED array panel, the width of the second ion implantation fence 2423 is not greater than 200 nm.

The micro LED array panel further includes a bottom isolation layer 2440 filled in the first trench 2412. Preferably, the material of the bottom isolation layer 2440 is one or more of SiO2, SiNx, Al2O3, AlN, HfO2, TiO2, or ZrO2. In addition, an IC backplane 2490 is formed under the first type semiconductor layer 2410 and is electrically connected with the first type semiconductor layer 2410 via a connection structure 2450. The micro LED array panel further includes a bottom contact 2460 formed at the bottom of the first type semiconductor layer 2410. An upper surface of the connection structure 2450 is connected with the bottom contact 2460 and a bottom of the connection structure 2450 is connected with the IC backplane 2490. The bottom contact 2460 is a protruding contact. In some embodiments, referring to **FIG. 4****,** the connection structure 2450 can be a metal bonding layer for bonding the micro LED with the IC backplane 2490. Additionally, in some embodiments, the bottom contact 2460 is a bottom contact layer.

Referring back to **FIG. 24****,** the micro LED array panel further includes a top contact 2480 and a top conductive layer 2470. The top contact 2480 is formed on the top of a second type semiconductor layer 2420. The top conductive layer 2470 is formed on the top of the second type semiconductor layer 2420 and the top contact 2480 and covers sidewalls and bottom of the second trench 2422. A conductive type of the top contact 2480 is the same as a conductive type of the second type semiconductor layer 2420. For example, the conductive type of the second type semiconductor layer 2420 is N type and the conductive type of the top contact 2480 is N type. The top contact 2480 is made of metal or metal alloy, such as, AuGe, AuGeNi, etc. The top contact 2480 is used for forming an ohmic contact between the top conductive layer 2470 and the second type semiconductor layer 2420, to optimize the electrical properties of the micro LEDs. The diameter of the top contact 2480 is about 20-50 nm and the thickness of the top contact 2480 is about 10~20nm.

Furthermore, a dielectric layer 2471 is formed on the sidewalls and bottom of the second trench 2422 under the top conductive layer 2470.

Further detail characters of the micro LED in the micro LED array panel can be found by reference to the above described micro LEDs, which will not be further described here.

The method of manufacturing the micro LED array panel at least includes manufacturing a micro LED. Details of manufacturing the micro LED can be found by reference to the description of steps 501-509 in the Embodiment 1 and the description of steps 1403-1406 in the Embodiment 2, which will not be further described here.

In Embodiments 1-3, a micro lens can be further formed on or above the top of the second type semiconductor layer, such as on the top surface of the top conductive layer, which can be understood by those skilled in the field.

The micro LED herein has a very small volume. The micro LED may be an organic LED or an inorganic LED. The micro LED can be applied in a micro LED array panel. The light emitting area of the micro LED array panel is very small, such as 1mm×1mm, 3mm×5 mm. In some embodiments, the light emitting area is the area of the micro LED array in the micro LED array panel. The micro LED array panel includes one or more micro LED arrays that form a pixel array in which the micro LEDs are pixels, such as a 1600×1200, 680×480, or 1920×1080 pixel array. The diameter of the micro LED is in the range of about 200nm~2µm. An IC backplane is formed at the back surface of the micro LED array and is electrically connected with the micro LED array. The IC backplane acquires signals such as image data from outside via signal lines to control corresponding micro LEDs to emit light or not.

It should be noted that relational terms herein such as "first" and "second" are used only to differentiate an entity or operation from another entity or operation, and do not require or imply any actual relationship or sequence between these entities or operations. Moreover, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items.

As used herein, unless specifically stated otherwise, the term "or" encompasses all possible combinations, except where infeasible. For example, if it is stated that a database may include A or B, then, unless specifically stated otherwise or infeasible, the database may include A, or B, or A and B. As a second example, if it is stated that a database may include A, B, or C, then, unless specifically stated otherwise or infeasible, the database may include A, or B, or C, or A and B, or A and C, or B and C, or A and B and C.

In the foregoing specification, embodiments have been described with reference to numerous specific details that can vary from implementation to implementation. Certain adaptations and modifications of the described embodiments can be made. Other embodiments can be apparent to those skilled in the art from consideration of the specification and practice of the invention disclosed herein. It is intended that the specification and examples be considered as exemplary only, with a true scope and spirit of the invention being indicated by the following claims. It is also intended that the sequence of steps shown in figures are only for illustrative purposes and are not intended to be limited to any particular sequence of steps. As such, those skilled in the art can appreciate that these steps can be performed in a different order while implementing the same method.

In the drawings and specification, there have been disclosed exemplary embodiments. However, many variations and modifications can be made to these embodiments. Accordingly, although specific terms are employed, they are used in a generic and descriptive sense only and not for purposes of limitation.

The following clauses describe certain embodiments of the present disclosure:
1. A micro LED, comprising:
   a first type semiconductor layer;
   a first type cap layer formed on the first type semiconductor layer; and
   a light emitting layer formed on the first type cap layer; wherein
   the first type semiconductor layer comprises a mesa structure, a trench, and an ion implantation fence separated from the mesa structure, the trench extending up through the first type semiconductor layer and extending up into at least part of the first type cap layer; and
   the ion implantation fence is formed around the trench and the trench is formed around the mesa structure, wherein an electrical resistance of the ion implantation fence is higher than an electrical resistance of the mesa structure.
2. The micro LED according to clause 1, wherein a top surface of the ion implantation fence is lower than or aligned with a top surface of the first type semiconductor layer.
3. The micro LED according to any of the previous clauses, wherein a bottom surface of the ion implantation fence is aligned with or higher than or lower than a bottom surface of the first type semiconductor layer.
4. The micro LED according to any of clauses 1-3, wherein a top surface of the ion implantation fence is lower than a top surface of the trench.
5. The micro LED according to any of clauses 1-4, wherein the trench extends up through the first type cap layer.
6. The micro LED according to clause 5, wherein the trench extends up into at least part of the light emitting layer.
7. The micro LED according to any of clauses 1-6, further comprising a second type cap layer formed on a top surface of the light emitting layer, and a second type semiconductor layer formed on the second type cap layer, wherein a conductive type of the second type semiconductor layer is different from the conductive type of the first type semiconductor layer.
8. The micro LED according to clause 7, wherein the trench further extends up through the first type cap layer, the light emitting layer and into an interior of the second type cap layer.
9. The micro LED according to clause 8, wherein the trench further extends up through the second type cap layer and into an interior of the second type semiconductor layer.
10. The micro LED according to clause 9, wherein the trench further extends up through the second type semiconductor layer.
11. The micro LED according to any of clauses 1-10, wherein the mesa structure comprises one or more stair structures.
12. The micro LED according to any of clauses 1-11, wherein a width of the trench is not greater than 50% of a width of the mesa structure.
13. The micro LED according to clause 12, wherein the width of the trench is not greater than 200 nm.
14. The micro LED according to any of clauses 1-13, wherein the ion implantation fence comprises a light absorption material, and the light absorption material is selected from one or more of GaAs, GaP, AlInP, GaN, InGaN, or AlGaN.
15. The micro LED according to any of clauses 1-14, wherein a thickness of the first type semiconductor layer is greater than a thickness of the light emitting layer.
16. The micro LED according to any of clauses 1-15, further comprising a bottom isolation layer filled in the trench.
17. The micro LED according to clause 16, wherein a material of the bottom isolation layer is selected from one or more of SiO2, SiNx, Al2O3, AlN, HfO2, TiO2, or ZrO2.
18. The micro LED according to any of clauses 1-17, wherein the ion implantation fence is formed by at least implanting ions into the first type semiconductor layer.
19. The micro LED according to clause 18, wherein the ions implanted into the ion implantation fence are selected from one or more of H, N, Ar, Kr, Xe, As, O, C, P, B, Si, S, Cl, or F.
20. The micro LED according to any of clauses 1-19, wherein a width of the ion implantation fence is not greater than 50% of a diameter of the mesa structure.
21. The micro LED according to clause 20, wherein the width of the ion implantation fence is not greater than 200 nm, the diameter of the mesa structure is not greater than 2500 nm, and a thickness of the first type semiconductor layer is not greater than 100 nm.
22. The micro LED according to clause 7, wherein a material of the first type semiconductor layer is one or more of GaAs, GaP, AlInP, GaN, InGaN, AlGaN, and a material of the second type semiconductor layer is one or more of GaAs, AlInP, GaInP, AlGaAs, AlGaInP, GaN, InGaN and AlGaN.
23. The micro LED according to any of clauses 1-22, further comprising an integrated circuit (IC) backplane formed under the first type semiconductor layer and a connection structure electrically connecting the IC backplane with the first type semiconductor layer.
24. The micro LED according to clause 23, wherein the connection structure is a connection pillar or a metal bonding layer.
25. The micro LED according to clause 23, further comprising a bottom contact formed on a bottom surface of the first type semiconductor layer, anupper surface of the connection structure being connected with the bottom contact and a bottom surface of the connection structure being connected with the IC backplane.
26. A micro LED array panel, comprising a plurality of micro LEDs according to any one of clauses 1 to 25.
27. A method for manufacturing a micro LED, comprising:
   providing an epitaxial structure, wherein the epitaxial structure comprises a first type semiconductor layer, a first type cap layer, a light emitting layer, a second type cap layer, and a second type semiconductor layer sequentially from top to bottom;
   patterning the first type semiconductor layer to form a mesa structure, a trench, and a fence;
   depositing a bottom contact on the mesa structure; and
   performing an ion implantation process into the fence to form an ion implantation fence.
28. The method according to clause 27, wherein after patterning the first type semiconductor layer to form thefirst mesa structure, thefirst trench, and thefirst fence, the method further comprises:
   depositing a bottom isolation layer on the first type semiconductor layer and the bottom contact;
   patterning the bottom isolation layer to expose the bottom contact;
   depositing metal material on the isolation layer and the bottom contact;
   grinding the metal material to a top surface of the bottom isolation layer, to form a connectionstructure; and
   turning the epitaxial structure upside down and bonding the connectionstructure with an Integrated Circuit (IC) backplane.
29. The method according to clause 28, wherein in depositing the bottom isolation layer on the isolation layer and the bottom contact, a material of the bottom isolation layer is selected from one or more of SiO2, SiNx, Al2O3, AlN, HfO2, TiO2, or ZrO2.
30.The method according to clause 28, wherein in providing the epitaxial structure, the epitaxial structure is grown on a substrate.
31. The method according to clause 30, wherein turning the epitaxial structure upside down and bonding the connectionstructure with the IC backplane further comprises:
   removing the substrate.
32. The method according to clause 30, wherein after turning the epitaxial structure upside down and bonding the connectionstructure with the IC backplane, the method further comprises:
   forming a top contact and a top conductive layer on a top surface of the mesa structure.
33. The method according to any of clauses 27-32, wherein patterning the first type semiconductor layer to form the mesa structure, the trench, and the fence further comprises:
   etching the first type semiconductor layer to a surface of the light emitting layer.
34. The method according to any of clauses 27-33, wherein patterning the first type semiconductor layer to form the mesa structure, the trench, and the fence further comprises:
   etching the first type semiconductor layer and the light emitting layer in sequence, and
   stopping the etching in the light emitting layer.
35. The method according to any of clauses 27-34, wherein patterning the first type semiconductor layer to form the mesa structure, the trench, and the fence further comprises:
   etching the first type semiconductor layer, the light emitting layer, and the second type semiconductor layer in sequence, and
   stopping the etching in the second type semiconductor layer.
36. The method according to any of clauses 27-35, wherein depositing the bottom contact on the mesa structure further comprises:
   forming a protective mask to protect an area where the bottom contact is not deposited;
   depositing material of the bottom contact on the protective mask and on the first type semiconductor layer; and
   removing the protective mask from the first type semiconductor layer and removing the material on the protective mask, to form the bottom contact on the mesa structure.
37. The method according to any of clauses 27-36, wherein performing theion implantation process into the first fence to form thefirst ion implantation fence further comprises:
   forming a protective mask on an area not being ion implanted while leaving the fence exposed;
   implanting ions into the fence; and
   removing the protective mask.
38. The method according to clause 37, wherein in performing the ion implantation process into the fence to form the ion implantation fence, implanting with an energy of 0~500Kev.
39. The method according to clause 37, wherein in performing the ion implantation process into the fence to form the ion implantation fence, implanting a dose of 1E10-9E17.
40. The method according to clause 37, wherein in performing the ion implantation process into the fence to form theion implantation fence, implanting ions into the fence selected from one or more of H, N, Ar, Kr, Xe, As, O, C, P, B, Si, S, Cl, or F.
41. The method according to clause 37, wherein in performing the ion implantation process into the fence to form the ion implantation fence, a width of the ion implantation fence is not greater than 50% of a diameter of the mesa structure.
42. The method according to clause 37, wherein in performing the ion implantation process into the fence to form the ion implantation fence, a width of the ion implantation fence is not greater than 200 nm, a diameter of the mesa structure is not greater than 2500 nm, and a thickness of the first type semiconductor layer is not greater than 300 nm.
43. The method according to any of clauses 27-42, wherein in patterning the first type semiconductor layer to form the mesa structure, the trench, and the fence, a width of the trench is not greater than 50% of a diameter of the mesa structure.
44. The method according to any of clauses 27-43, wherein a conductive type of the first type semiconductor layer is P type and a conductive type of the second type semiconductor layer is N type, wherein a material of the first type semiconductor layer is selected from one or more of p-GaAs,p-GaP, p-AlInP, p-GaN, p-InGaN, or p-AlGaN, and a material of the second type semiconductor layer is selected from one or more of n-GaAs, n-AlInP, n-GaInP, n-AlGaAs, n-AlGaInP, n-GaN, n-InGaN, or n-AlGaN.
45. The method according to clause 44, wherein the ion implantation fence comprises a light absorption material.
46. The method according to clause 45, wherein the light absorption material is selected from one or more of GaAs, GaP, AlInP, GaN, InGaN, or AlGaN.
47. A micro LED, comprising:
   a first type semiconductor layer;
   a first type cap layer formed on the first type semiconductor layer;
   a light emitting layer formed on the first type cap layer;
   a second type cap layer formed on the light emitting layer;
   a second type semiconductor layer formed on the second type caplayer; and
   an integrated circuit (IC) back plane formed at a bottom surface of the first type semiconductor layer; wherein
   the second type semiconductor layer comprises a mesa structure, a trench, and an ion implantation fence separated from the mesa structure,the trench extending down through the second type semiconductor layer and extending down into at least part of the second type cap layer; and
   the ion implantation fence is formed around the trench and the trench is formed around the mesa structure, wherein an electrical resistance of the ion implantation fence is higher than an electrical resistance of the mesa structure;
   wherein a conductive type of the first type semiconductor layer is different from a conductive type of the second type semiconductor layer.
48. The micro LED according to clause 47, wherein a bottom surface of the ion implantation fence is higher than or aligned with a bottom surface of the second type semiconductor layer.
49. The micro LED according to any of clauses 47-48, wherein a top surface of the ion implantation fence is aligned with or higher than or lower than a top surface of the second type semiconductor layer.
50. The micro LED according to any of clauses 47-49, wherein a bottom surface of the ion implantation fence is higher than a bottom surface of the trench.
51. The micro LED according to any of clauses 47-50, wherein the trench extends down through the second type cap layer.
52. The micro LED according to clause 51, wherein the trench further extends down into at least part of the light emitting layer.
53. The micro LED according to clause 52, wherein the trench further extends down through the light emitting layer and into an interior of the first type cap layer; or the trench further extends down through the light emitting layer and the first type cap layer and extends into an interior of the first type semiconductor layer.
54. The micro LED according to clause 53, wherein the trench further extends down through the first type semiconductor layer.
55. The micro LED according to any of clauses 47-54, wherein the mesa structure comprises one or more stair structures.
56. The micro LED according to any of clauses 47-55, wherein a width of the trench is not greater than 50% of a width of the mesa structure.
57. The micro LED according to clause 56, wherein a width of the trench is not greater than 200 nm.
58. The micro LED according to any of clauses 47-57, wherein the ion implantation fence comprises a light absorption material, and the light absorption material is selected from one or more of GaAs, GaP, AlInP, GaN, InGaN, or AlGaN.
59. The micro LED according to any of clauses 47-58, wherein a thickness of the second type semiconductor layer is larger than a thickness of the light emitting layer.
60. The micro LED according to any of clauses 47-59, further comprising a bottom isolation layer formed between a bottom surface of the first type semiconductor layer and a top surface of the IC backplane.
61. The micro LED according to clause 60, wherein a material of the bottom isolation layer is selected from one or more of SiO2, SiNx, Al2O3, AlN, HfO2, TiO2, or ZrO2.
62.The micro LED according to any of clauses 47-61, wherein the ion implantation fence is formed by at least implanting ions into the second type semiconductor layer.
63. The micro LED according to clause 62, wherein the ions implanted into the second type semiconductor layerareselected from one or more of H, N, Ar, Kr, Xe, As, O, C, P, B, Si, S, Cl, or F.
64. The micro LED according to any of clauses 47-63, wherein a width of the ion implantation fence is not greater than 50% of a diameter of the mesa structure.
65. The micro LED according to clause 62, wherein the width of the ion implantation fence is not greater than 200 nm, the diameter of the mesa structure is not greater than 2500 nm, and a thickness of the first type semiconductor layer is not greater than 300 nm.
66. The micro LED according to any of clauses 47-65, wherein a material of the first type semiconductor layer is one or more of GaAs, GaP, AlInP, GaN, InGaN, AlGaN, and a material of the second type semiconductor layer is one or more of GaAs, AlInP, GaInP, AlGaAs, AlGaInP, GaN, InGaN and AlGaN.
67. The micro LED according to any of clauses 47-66, further comprising a connection structure electrically connecting the IC backplane with the first type semiconductor layer.
68. The micro LED according to clause 67, wherein the connection structure is a connection pillar or a metal bonding layer.
69. The micro LED according to clause 67, further comprising a bottom contact formed on a bottom surface of the first type semiconductor layer, anupper surface of the connection structure being connected with the bottom contact and a bottom surface of the connection structure being connected with the IC backplane.
70. A micro LED array panel, comprising a plurality of micro LEDs according to any one of clauses 47 to 69.
71. A method for manufacturing a micro LED, comprising:
   providing an epitaxial structure, wherein the epitaxial structure comprises a first type semiconductor layer, a first type cap layer, a light emitting layer, a second type cap layer, and a second type semiconductor layer sequentially from top to bottom;
   bonding the epitaxial structure with an integrated circuit (IC) backplane;
   patterning the second type semiconductor layer to form a mesa structure, a trench, and a fence;
   depositing a top contact on the mesa structure;
   performing an ion implantation process into the fence; and
   depositing a top conductive layer on a top surface of the second type semiconductor layer, on a top contact, and in the trench.
72. The method according to clause 71, wherein providing the epitaxial structure further comprises:
   depositing a bottom contact layer on a top surface of the first type semiconductor layer; and
   depositing a metal bonding layer on a top surface of the bottom contact layer.
73. The method according to clause 72, wherein bonding the epitaxial structure with the IC backplane further comprises:
   turning the epitaxial structure upside down; and
   bonding the metal bonding layer with a contact pad on the IC backplane.
74. The method according to clause 73, wherein in providing the epitaxial structure, the epitaxial structure is grown on a substrate.
75. The method according to clause 74, wherein bonding the epitaxial structure with the IC backplane further comprises:
   removing the substrate.
76. The method according to any of clauses 71-75, wherein patterning the second type semiconductor layer to form the mesa structure, the trench, and the fence further comprises:
   etching the second type semiconductor layer to a surface of the light emitting layer.
77. The method according to any of clauses 71-76, wherein patterning the second type semiconductor layer to form the mesa structure, the trench, and the fence further comprises:
   etching the second type semiconductor layer and the light emitting layer in sequence, and
   stopping the etching in the light emitting layer.
78. The method according to any of clauses 71-77, wherein the patterning the second type semiconductor layer to form the mesa structure, the trench, and the fence further comprises:
   etching the second type semiconductor layer, the light emitting layer, and the first type semiconductor layer in sequence, and
   stopping the etching in the first type semiconductor layer.
79. The method according to any of clauses 71-78, wherein depositing the top contact on the mesa structure further comprises:
   forming a protective mask to protect an area where the bottom contact is not being deposited;
   depositing a material of the top contact on the protective mask;
   removing the protective mask from the second type semiconductor layer and removing the material of the top contact on the protective mask, to form the top contact on the mesa structure.
80. The method according to any of clauses 71-79, wherein performing the ion implantation process into the fence further comprises:
   forming a protective mask on an area not being ion implanted while leaving the fence exposed;
   implanting ions into the fence; and
   removing the protective mask.
81. The method according to clause 80, wherein in performing the ion implantation process into the fence, implanting with an energy 0~500KeV.
82. The method according to clause 80, wherein in performing the ion implantation process into the fence, implanting a dose of 1E10-9E17.
83. The method according to clause 80, wherein in performing the ion implantation process into the fence, implanting ions into the ion implantation fence selected from one or more of H, N, Ar, Kr, Xe, As, O, C, P, B, Si, S, Cl, or F.
84. The method according to clause 80, wherein in performing the ion implantation process into the fence, a width of the ion implantation fence is not greater than 50% of a diameter of the mesa structure.
85. The method according to clause 80 wherein in performing the ion implantation process into the fence, a width of the ion implantation fence is not greater than 200 nm, a diameter of the mesa structure is not greater than 2500 nm, and a thickness of the second type semiconductor layer is not greater than 100 nm.
86. The method according to any of clauses 71-85, wherein a conductive type of the first type semiconductor layer is P type and a conductive type of the second type semiconductor layer is N type; wherein a material of the first type semiconductor layer is selected from one or more of p-GaAs,p-GaP, p-AlInP, p-GaN, p-InGaN, or p-AlGaN, and a material of the second type semiconductor layer is selected from one or more of n-GaAs, n-AlInP, n-GaInP, n-AlGaAs, n-AlGaInP, n-GaN, n-InGaN, or n-AlGaN.
87. The method according to clause 86, wherein the ion implantation fence comprises a light absorption material.
88. The method according to clause 87, wherein the light absorption material is selected from one or more of GaAs, GaP, AlInP, GaN, InGaN, or AlGaN.
89. A micro LED, comprising:
   a first type semiconductor layer;
   a first type cap layer formed on the first type semiconductor layer;
   a light emitting layer formed on the first type cap layer;
   a second type cap layer formed on the light emitting layer; and
   a second type semiconductor layer formed on the second type cap layer;
   wherein the first type semiconductor layer comprises a first mesa structure, a first trench, and a first ion implantation fence separated from the first mesa structure, the first trench extending up through the first type semiconductor layer and extending up into at least part of the first type cap layer; and
   the first ion implantation fence is formed around the first trench and the first trench is formed around the first mesa structure; and an electrical resistance of the first ion implantation fence is higher than an electrical resistance of the first mesa structure; and
   the second type semiconductor layer comprises a second mesa structure, a second trench, and a second ion implantation fence separated from the second mesa structure; and
   the second ion implantation fence is formed around the second trench and the second trench is formed around the second mesa structure; and an electrical resistance of the second ion implantation fence is higher than an electrical resistance of the second mesa structure;
   wherein a conductive type of the first type semiconductor layer is different from a conductive type of the second type semiconductor layer.
90. The micro LED according to clause 89, wherein a top surface of the first trench does not touch the bottom of the second trench; and part of the light emitting layer is disposedbetween the top surface of the first trench and the bottom surface of the second trench.
91. The micro LED according to clause 90, wherein a top surface of the first ion implantation fence is lower than or aligned witha top surface of the first type semiconductor layer; and a bottom surface of the second ion implantation fence is higher than or aligned with a bottom surface of the second type semiconductor layer.
92. The micro LED according to any of clauses 89-91, wherein a bottom surface of the first ion implantation fence is aligned with or higher than or lower than a bottom surface of the first type semiconductor layer; and
   a top surface of the second ion implantation fence is aligned with or higher than or lower than a top surface of the second type semiconductor layer.
93. The micro LED according to any of clauses 89-92, wherein a top surface of the first ion implantation fence is lower than a top surface of the first trench.
94. The micro LED according to any of clauses 89-93, wherein the second trench does not extend down through the second type semiconductor layer.
95. The micro LED according to clause 94, wherein the second trench extends down through the second type semiconductor layer and extends down into at least part of the second type cap layer, or extends down through the second type cap layer and extends down into at least part of the light emitting layer.
96. The micro LED according to clause 95, wherein a bottom surface of the second ion implantation fence is higher than a bottom surface of the second trench.
97. The micro LED according to any of clauses 89-96, wherein a top surface of the first trench is directly connected with a bottom surface of the second trench, without the light emitting layer disposed between the first trench and the second trench.
98. The micro LED according to any of clauses 89-97, wherein the first mesa structure comprises one or more stair structures and the second mesa structure comprises one or more stair structures.
99. The micro LED according to any of clauses 89-98, wherein a width of the first trench is not greater than 50% of a width of the first mesa structure; and/or, a width of the second trench is not greater than 50% of a width of the second mesa structure.
100. The micro LED according to clause 99, wherein the width of the first trench is not greater than 200 nm; and/or, the width of the second trench is not greater than 200 nm.
101. The micro LED according to any of clauses 89-100, wherein the first ion implantation fence comprises a first light absorption material, and the second ion implantation fence comprises a second light absorption material; wherein a conductive type of the first light absorption material is the same as a conductive of the first type semiconductor layer, and a conductive type of the second light absorption material is the same as a conductive of the second type semiconductor layer.
102. The micro LED according to clause 101, wherein the first light absorption material is selected from one or more of GaAs, GaP, AlInP, GaN, InGaN, or AlGaN; and/or, the second light absorption material is selected from one or more of GaAs, GaP, AlInP, GaN, InGaN, or AlGaN.
103. The micro LED according to any of clauses 89-102, wherein a thickness of the first type semiconductor layer is greater than a thickness of the light emitting layer, a thickness of the second type semiconductor layer is greater than the thickness of the light emitting layer,and the thickness of the first type semiconductor layer is greater than the thickness of the second type semiconductor layer.
104. The micro LED according to any of clauses 89-103, further comprising a bottom isolation layer formed between a bottom surface of the first type semiconductor layer and a top surface of the IC backplane.
105. The micro LED according to clause 104, wherein a material of the bottom isolation layer is selected from one or more of SiO2, SiNx, Al2O3, AlN, HfO2, TiO2, or ZrO2.
106. The micro LED according to any of clauses 89-105, wherein the first ion implantation fence is formed by at least implanting ions into the first type semiconductor layer and the second ion implantation fence is formed by at least implanting ions into the second type semiconductor layer.
107. The micro LED according to clause 106, wherein the ions implanted into the first type semiconductor layerareselected from one or more of H, N, Ar, Kr, Xe, As, O, C, P, B, Si, S, Cl, or F; the ions implanted into the second type semiconductor layerareselected from one or more of H, N, Ar, Kr, Xe, As, O, C, P, B, Si, S, Cl, or F.
108. The micro LED according to any of clauses 89-107, wherein a width of the first ion implantation fence is not greater than 50% of a diameter of the first mesa structure,and a width of the second ion implantation fence is not greater than 50% of a diameter of the second mesa structure.
109. The micro LED according to clause 108, wherein the width of the first ion implantation fence is not greater than 200 nm, the diameter of the first mesa structure is not greater than 2500 nm, and a thickness of the first type semiconductor layer is not greater than 100 nm; and the width of the second ion implantation fence is not greater than 200 nm, the diameter of the second mesa structure is not greater than 2500 nm, and a thickness of the second type semiconductor layer is not greater than 300 nm.
110. The micro LED according to any of clauses 89-109, wherein a material of the first type semiconductor layer is selected from one or more of GaAs, GaP, AlInP, GaN, InGaN, or AlGaN; and a material of the second type semiconductor layer is selected from one or more of GaAs, AlInP, GaInP, AlGaAs, AlGaInP, GaN, InGaN, or AlGaN.
111. The micro LED according to any of clauses 89-110, further comprising an integrated circuit (IC) backplane formed under the first type semiconductor layer and a connection structure electrically connecting the IC backplane with the first type semiconductor layer.
112. The micro LED according to clause 111, wherein the connection structure is a connection pillar or a metal bonding layer.
113. The micro LED according to clause 111, further comprising: comprising a bottom contact formed on a bottom surface of the first type semiconductor layer, an upper a connection structure surface of the connection structure being connected with the bottom contact and a bottom surface of the connection structure being connected with the IC backplane.
114. A micro LED array panel, comprising a plurality of micro LEDs according to any one of clauses 89 to 113.
115. A method for manufacturing a micro LED, comprising:
   a process I comprising patterning a first type semiconductor layer; and implanting first ions into the first type semiconductor layer; and
   a process II comprising patterning a second type semiconductor layer; and implanting second ions into the second type semiconductor layer.
116. The method according to clause 115, wherein the process I further comprises:
   providing an epitaxial structure, wherein the epitaxial structure comprises a first type semiconductor layer, a first type cap layer, a light emitting layer, a second type cap layer, and a second type semiconductor layer sequentially from top to bottom;
   patterning the first type semiconductor layer to form a mesa structure, a trench, and a fence;
   depositing a bottom contact on the mesa structure;
   performing an ion implantation process into the fence, to form an ion implantation fence;
   depositing a bottom isolation layer on the first type semiconductor layer and the bottom contact;
   patterning the bottom isolation layer to expose the bottom contact;
   depositing metal material on the isolation layer and the bottom contact;
   grinding the metal material to a top surface of the bottom isolation layer, to form a connection structure; and
   turning the epitaxial structure upside down and bonding the connection structure with an integrated circuit (IC) backplane.
117. The method according to clause 116, wherein patterning the first type semiconductor layer to form the mesa structure, the trench, and the fence further comprises:
   etching the first type semiconductor layer to a surface of the light emitting layer.
118. The method according to clause 116, wherein patterning the first type semiconductor layer to form the mesa structure, the trench, and the fence further comprises:
   etching the first type semiconductor layer and the light emitting layer in sequence, and
   stopping the etching in the light emitting layer.
119. The method according to clause 116, wherein patterning the first type semiconductor layer to form the mesa structure, the trench, and the fence further comprises:
   etching the first type semiconductor layer, the light emitting layer, and the second type semiconductor layer in sequence, and
   stopping the etching in the second type semiconductor layer.
120. The method according to clause 116, wherein depositing a bottom contact on the mesa structure further comprises:
   forming a protective mask to protect an area where the bottom contact is not being deposited;
   depositing a material of the bottom contact on the protective mask and on the first type semiconductor layer; and
   removing the protective mask from the first type semiconductor layer and removing the material on the protective mask, to form the bottom contact on the mesa structure.
121. The method according to clause 116, wherein performing the ion implantation process into the fence to form the ion implantation fence further comprises:
   forming a protective mask on an area not being ion implanted while leaving the fence exposed;
   implanting ions into the fence; and
   removing the protective mask.
122. The method according to clause 121, wherein in performing the ion implantation process into the fence to form the ion implantation fence, implanting with an energy of 0~500Kev, and implanting a dose of 1E10-9E17.
123. The method according to clause 121, wherein in performing the ion implantation process into the fence to form the ion implantation fence, implanting ions into the fence selected from one or more of H, N, Ar, Kr, Xe, As, O, C, P, B, Si, S, Cl, or F.
124. The method according to clause 121, wherein in performing the ion implantation process into the fence to form the ion implantation fence, a width of the ion implantation fence is not greater than 50% of a diameter of the mesa structure,the width of the ion implantation fence is not greater than 200 nm, the diameter of the mesa structure is not greater than 2500 nm, and a thickness of the first type semiconductor layer is not greater than 300 nm.
125. The method according to clause 116, wherein in patterning the first type semiconductor layer to form the mesa structure, the trench, and the fence, a width of the trench is not greater than 50% of a diameter of the mesa structure.
126. The method according to any of clauses 115-125, wherein the mesa structure, the trench, and the fence are a first mesa structure, a first trench, and a first fence, respectively; wherein the process II further comprises:
   patterning the second type semiconductor layer to form a second mesa structure, a second trench, and a second fence;
   depositing a top contact on the second mesa structure;
   performing an ion implantation process into the second fence;
   depositing a top conductive layer on a top surface of the second type semiconductor layer, on the top contact, and in the second trench.
127. The method according to clause 126, wherein patterning the second type semiconductor layer to form the second mesa structure, the second trench, and the second fence further comprises:
   etching the second type semiconductor layer to a surface of the light emitting layer.
128. The method according to clause 126, wherein patterning the second type semiconductor layer to form the second mesa structure, the second trench, and the second fence further comprises:
   etching the second type semiconductor layer and the light emitting layer in sequence, and
   stopping the etching in the light emitting layer.
129. The method according to clause 126, wherein patterning the second type semiconductor layer to form the second mesa structure, the second trench, and the second fence further comprises:
   etching the second type semiconductor layer, the light emitting layer and the first type semiconductor layer in sequence, and
   stopping the etching in the first type semiconductor layer.
130. The method according to clause 126, wherein depositing the top contact on the second mesa structure further comprises:
   forming a protective mask to protect an area where the bottom contact is not being deposited;
   depositing a material of the top contact on the protective mask;
   removing the protective mask from the second type semiconductor layer and removing the material of the top contact on the protective mask, to form the top contact on the second mesa structure.
131. The method according to clause 126, wherein performing the ion implantation process into the second fence further comprises:
   forming a protective mask on an area not being implanted while leaving the second fence exposed;
   implanting the ions into the second fence; and
   removing the protective mask.
132. The method according to clause 125, wherein in performing the ion implantation process into the second fence, implanting with an energy of 0~500KeV and implanting a dose of 1E10-9E17.
133. The method according to clause 125, wherein in performing the ion implantation process into the second fence, implanting ions into the second fence selected from one or more of H, N, Ar, Kr, Xe, As, O, C, P, B, Si, S, Cl, or F.
134. The method according to clause 125, wherein in performing the ion implantation process into the second fence, a width of the second ion implantation fence is not greater than 50% of a diameter of the second mesa structure,the width of the second ion implantation fence is not greater than 200 nm, the diameter of the second mesa structure is not greater than 2500 nm, and a thickness of the second type semiconductor layer is not greater than 100 nm.
135. The method according to clause 116, wherein in providing the epitaxial structure, the epitaxial structure is grown on a substrate; the turning the epitaxial structure upside down and bonding the connection structure with the IC backplane further comprises:
   removing the substrate.
136. The method according to clause 116, wherein in depositing the bottom isolation layer on the first type semiconductor layer and the bottom contact, a material of the bottom isolation layer is selected from one or more of SiO2, SiNx, Al2O3, AlN, HfO2, TiO2, or ZrO2.
137. The method according to clause 116, wherein the ion implantation fence comprises a light absorption material.
138. The method according to clause 137, wherein a conductive type of the light absorption material is the same as a conductive type of the first type semiconductor layer, and the light absorption material is selected from one or more of GaAs, GaP, AlInP, GaN, InGaN, or AlGaN.
139. The method according to clause 116, wherein a conductive type of the first type semiconductor layer is P type and a conductive type of the second type semiconductor layer is N type; and a material of the first type semiconductor layer is selected from one or more of p-GaAs,p-GaP, p-AlInP, p-GaN, p-InGaN or p-AlGaN; and a material of the second type semiconductor layer is selected from one or more of n-GaAs, n-AlInP, n-GaInP, n-AlGaAs, n-AlGaInP, n-GaN, n-InGaN, or n-AlGaN.

## Claims

1. A micro LED, comprising:
a first type semiconductor layer;
a first type cap layer formed on the first type semiconductor layer;
a light emitting layer formed on the first type cap layer;
a second type cap layer formed on the light emitting layer; and
a second type semiconductor layer formed on the second type cap layer;
wherein the first type semiconductor layer comprises a first mesa structure, a first trench, and a first ion implantation fence separated from the first mesa structure, the first trench extending up through the first type semiconductor layer and extending up into at least part of the first type cap layer; and
the first ion implantation fence is formed around the first trench and the first trench is formed around the first mesa structure; and an electrical resistance of the first ion implantation fence is higher than an electrical resistance of the first mesa structure; and
the second type semiconductor layer comprises a second mesa structure, a second trench, and a second ion implantation fence separated from the second mesa structure; and
the second ion implantation fence is formed around the second trench and the second trench is formed around the second mesa structure; and an electrical resistance of the second ion implantation fence is higher than an electrical resistance of the second mesa structure;
wherein a conductive type of the first type semiconductor layer is different from a conductive type of the second type semiconductor layer.

2. The micro LED according to claim 1, wherein a top surface of the first trench does not touch the bottom of the second trench; and part of the light emitting layer is disposed between the top surface of the first trench and the bottom surface of the second trench; optionally wherein
a top surface of the first ion implantation fence is lower than or aligned with a top surface of the first type semiconductor layer; and a bottom surface of the second ion implantation fence is higher than or aligned with a bottom surface of the second type semiconductor layer.

3. The micro LED according to claim 1, wherein a bottom surface of the first ion implantation fence is aligned with or higher than or lower than a bottom surface of the first type semiconductor layer; and
a top surface of the second ion implantation fence is aligned with or higher than or lower than a top surface of the second type semiconductor layer; or wherein
a top surface of the first ion implantation fence is lower than a top surface of the first trench.

4. The micro LED according to claim 1, wherein the second trench does not extend down through the second type semiconductor layer; optionally wherein
the second trench extends down through the second type semiconductor layer and extends down into at least part of the second type cap layer, or extends down through the second type cap layer and extends down into at least part of the light emitting layer; and optionally
wherein a bottom surface of the second ion implantation fence is higher than a bottom surface of the second trench.

5. The micro LED according to claim 1, wherein a top surface of the first trench is directly connected with a bottom surface of the second trench, without the light emitting layer disposed between the first trench and the second trench.

6. The micro LED according to claim 1, wherein the first mesa structure comprises one or more stair structures and the second mesa structure comprises one or more stair structures.

7. The micro LED according to claim 1, wherein a width of the first trench is not greater than 50% of a width of the first mesa structure; and/or, a width of the second trench is not greater than 50% of a width of the second mesa structure; and optionally
wherein the width of the first trench is not greater than 200 nm; and/or, the width of the second trench is not greater than 200 nm.

8. The micro LED according to claim 1, wherein the first ion implantation fence comprises a first light absorption material, and the second ion implantation fence comprises a second light absorption material; wherein a conductive type of the first light absorption material is the same as a conductive of the first type semiconductor layer, and a conductive type of the second light absorption material is the same as a conductive of the second type semiconductor layer; and optionally
wherein the first light absorption material is selected from one or more of GaAs, GaP, AlInP, GaN, InGaN, or AlGaN; and/or, the second light absorption material is selected from one or more of GaAs, GaP, AlInP, GaN, InGaN, or AlGaN.

9. The micro LED according to claim 1, wherein a thickness of the first type semiconductor layer is greater than a thickness of the light emitting layer, a thickness of the second type semiconductor layer is greater than the thickness of the light emitting layer, and the thickness of the first type semiconductor layer is greater than the thickness of the second type semiconductor layer.

10. The micro LED according to claim 1, further comprising a bottom isolation layer formed between a bottom surface of the first type semiconductor layer and a top surface of the IC backplane; and optionally
wherein a material of the bottom isolation layer is selected from one or more of SiO2, SiNx, Al2O3, AlN, HfO2, TiO2, or ZrO2.

11. The micro LED according to claim 1, wherein the first ion implantation fence is formed by at least implanting ions into the first type semiconductor layer and the second ion implantation fence is formed by at least implanting ions into the second type semiconductor layer; and optionally
wherein the ions implanted into the first type semiconductor layer are selected from one or more of H, N, Ar, Kr, Xe, As, O, C, P, B, Si, S, Cl, or F; the ions implanted into the second type semiconductor layer are selected from one or more of H, N, Ar, Kr, Xe, As, O, C, P, B, Si, S, Cl, or F.

12. The micro LED according to claim 1, wherein a width of the first ion implantation fence is not greater than 50% of a diameter of the first mesa structure, and a width of the second ion implantation fence is not greater than 50% of a diameter of the second mesa structure; and optionally
wherein the width of the first ion implantation fence is not greater than 200 nm, the diameter of the first mesa structure is not greater than 2500 nm, and a thickness of the first type semiconductor layer is not greater than 100 nm; and
the width of the second ion implantation fence is not greater than 200 nm, the diameter of the second mesa structure is not greater than 2500 nm, and a thickness of the second type semiconductor layer is not greater than 300 nm.

13. The micro LED according to claim 1, wherein a material of the first type semiconductor layer is selected from one or more of GaAs, GaP, AlInP, GaN, InGaN, or AlGaN; and a material of the second type semiconductor layer is selected from one or more of GaAs, AlInP, GaInP, AlGaAs, AlGaInP, GaN, InGaN, or AlGaN.

14. The micro LED according to claim 1, further comprising an integrated circuit (IC) backplane formed under the first type semiconductor layer and a connection structure electrically connecting the IC backplane with the first type semiconductor layer; and optionally
wherein the connection structure is a connection pillar or a metal bonding layer; or wherein the micro LED further comprises:
a bottom contact formed on a bottom surface of the first type semiconductor layer, an upper a connection structure 1550 surface of the connection structure being connected with the bottom contact and a bottom surface of the connection structure being connected with the IC backplane.

15. A micro LED array panel, comprising a plurality of micro LEDs according to any one of claims 1 to 14.
